# EUROPEAN PATENT APPLICATION

(11) **EP 4 787 217 A1**
(43) Date of publication of application: **05.08.2026**
(21) Application number: 25212279.1
(22) Date of filing: 30.10.2025
(51) Int. Cl.: G06F 30/15, G05B 17/00, G05B 17/02, G06F 30/20, G06F 30/27, G06F 11/07, G06F 40/30, G06F 30/30

(54) **SYSTEM AND METHOD FOR VIRTUALIZING ELECTRONIC CONTROL SYSTEMS WITH PREDICTIVE ANOMALY DETECTION FOR DIGITAL TWIN APPLICATIONS**

(30) Priority: 30.01.2025 EP 25155018; 25.02.2025 EP 25159818
(71) Applicant: AUMOVIO Germany GmbH, 60488 Frankfurt am Main (DE)
(72) Inventor: Keyrouz, Fred, 60488 Frankfurt am Main (DE); Hruschka, Martin, 60488 Frankfurt am Main (DE); Hermann, Torsten, 60488 Frankfurt am Main (DE)
(74) Representative: Aumovio Corporation

(57) **Abstract**

A system and method for virtualizing an electronic control system (ECS) is disclosed. The method comprises abstracting signal properties in ECS components by categorizing signals into analog and digital groups to enable distinct processing paths; encapsulating peripheral models with standardized interfaces that match the respective ECS component interfaces; obtaining signal operations including logical operations for digital signals and mathematical operations for analog signals to simulate signal processing between components; executing said signal operations to evaluate signal behavior; and using the evaluation of the signal processing and/or the executed signal operations as input to a machine learning model configured to predict cascading malfunctions across multiple ECS components. The method further comprises adapting ECS components that are predicted to malfunction using software-based and/or hardware-based corrective actions. The system may include modules corresponding to each method step and may support semantic interpretation of signal data, dynamic validation, modular logging with interchangeable backends, and integration into continuous integration (CI) or hardware-in-the-loop (HiL) testing pipelines. The invention enables proactive fault detection, scalable ECS simulation, and enhanced system reliability in safety-critical domains.

## Description

### Field of the Invention

The present invention relates to the field of electronic control systems (ECS), and more particularly to methods and systems for virtualizing ECS architectures comprising multiple interconnected components, including microcontrollers and peripheral devices. The invention further relates to the simulation, validation, and predictive analysis of signal processing within such systems, with the goal of improving reliability, safety, and fault tolerance in complex embedded control environments, such as those found in automotive, aerospace, and industrial automation domains.

### Background of the Invention

Modern electronic control systems (ECS) are increasingly complex, comprising numerous microcontrollers, sensors, actuators, and peripheral components interconnected through intricate signal wiring. These systems are responsible for critical real-time functions, such as steering, braking, powertrain control, and safety monitoring in vehicles. As the number of components and interconnections grows, so does the difficulty of ensuring system-wide correctness, consistency, and safety. Traditional ECS development workflows rely heavily on static validation techniques, such as rule-based configuration checks, interface conformance testing, and signal range verification. While these methods are effective for detecting certain classes of errors, they fall short in identifying dynamic or context-dependent anomalies that emerge only during runtime or under specific operational conditions.

One significant limitation of existing approaches is their inability to detect conflicting signal interpretations across multiple ECUs. For example, in a distributed steering control system, one ECU may detect a sensor fault while another continues to process the same sensor data as valid. This can lead to inconsistent torque validity flags, causing the steering assistance logic to oscillate unpredictably between active and inactive states. Such behavior, while potentially undetected in simulation, can result in hazardous real-world consequences.

Another critical shortcoming lies in the lack of dynamic validation. Many current tools validate ECS configurations only at design time, without monitoring the temporal evolution of signal states during simulation. This prevents the detection of kaskadierende Fehler (cascading failures), where a fault in one component propagates through dependent components, leading to systemic instability.

Furthermore, physical plausibility checks are often absent. For instance, a faulty speed sensor might report implausible values that pass structural validation but cause downstream logic to behave dangerously - such as enabling high-speed assistance during braking. Without runtime checks for semantic consistency or contextual correctness, such issues remain latent until field deployment.

Efforts to improve ECS validation have included the use of model-based development environments and hardware-in-the-loop (HiL) testing. However, these approaches are resource-intensive, require significant manual configuration, and still rely on predefined test cases that may not cover all edge conditions. Moreover, they typically lack predictive capabilities, offering no mechanism to anticipate faults before they manifest.

Recent research has explored the use of machine learning (ML) for anomaly detection in control systems. However, these solutions are often limited to post-deployment monitoring or offline analysis. They rarely integrate directly into ECS simulation environments, and they seldom address cascading failure prediction across multiple components. Additionally, ML-based approaches are typically decoupled from the signal-level semantics and logical structure of ECS architectures, limiting their interpretability and effectiveness.

Another challenge is the lack of modularity and extensibility in existing ECS simulation frameworks. Signal logging, validation, and adaptation mechanisms are often tightly coupled to specific hardware or software stacks, making it difficult to integrate advanced analytics, such as semantic reasoning or ML-based prediction, without significant reengineering.

### Summary of the Invention

The present invention overcomes the aforementioned limitations by providing a modular, extensible system and method for virtualizing electronic control systems, which integrates signal abstraction, peripheral modeling, formalized signal operations, and machine learning-based prediction of cascading malfunctions. The invention enables real-time signal consistency validation, semantic anomaly detection, and proactive adaptation of ECS components based on predicted risks, thereby enhancing system reliability and safety.

The system comprises distinct modules for signal abstraction, peripheral model interfacing, signal operation execution, machine learning-based evaluation, and component adaptation. The architecture supports modular logging backends, prefix notation for signal logic, and graph-based signal propagation ordering, enabling efficient simulation and traceability. Furthermore, the invention supports integration into continuous integration (CI) and hardware-in-the-loop (HiL) pipelines, facilitating automated validation throughout the development lifecycle.

By combining formal methods, semantic reasoning, and predictive analytics, the invention provides a comprehensive framework for early detection and mitigation of faults in complex ECS environments, addressing both known and previously undetectable failure modes. The disclosed solution is covered by the subject-matter of the appended independent claims. The appended dependent claims address optional embodiments of the present disclosure.

According to one aspect of the present disclosure, there is provided a method for virtualizing an electronic control system, ECS, comprising: abstracting, technical details of signals in ECS components into groups, including analog signals group and digital signals group, wherein the groups are strictly separated, thereby facilitating distinct processing paths for different signal types; obtaining peripheral models associated with respective ECS components, wherein each peripheral model comprises interfaces that correspond to respective interfaces of the respective ECS component, each interface of the peripheral model being associated with a signal, which is an analog signal or a digital signal, an input signal or an output signal, matching an interface signal of the respective ECS component, said signal can be acquired from the respective interface of the respective ECS component; obtaining, for simulating signal processing between the peripheral models, signal operations to virtualize signal processing between the respective ECS component, said signal operations including logical operations for the digital signals, and mathematical operations for the analog signals, thereby providing a unified framework for signal processing; executing the signal operations to evaluate the signal processing between the ECS components; using said evaluation of the signal processing and/or the executed signal operations by a machine learning model to predict cascading malfunctions across multiple ECS components; adapting the ECS components that are predicted to malfunction, thereby ensuring continuous and reliable operation of the ECS.

By abstracting the technical details of signals in ECS components into distinct groups, including analog signals and digital signals, the method facilitates distinct processing paths for different signal types. This separation enhances the efficiency a of signal processing by allowing tailored operations for each signal type, thereby reducing the complexity of handling mixed signal types.

For example, the abstraction of said signal details may include representing analog signals as floating-point values for precise mathematical operations, simplifying digital signals to binary states for straightforward logical processing, and/or reducing PWM signals to their duty cycles to avoid complex state simulations. By removing transient behaviors and assuming ideal conditions, the method ensures efficient and accurate signal processing, significantly enhancing the virtualization of ECS components compared to state-of-the-art methods.

For example, in an Anti-lock Braking System (ABS), wheel speed sensors generate analog signals, while brake light indicators generate digital signals. By categorizing these signals, the system can process each type more efficiently, ensuring accurate and timely responses.

For example, the abstraction of said signal details may comprise representing only the input-output relationships of each ECS component or chip (e.g. rather than the complex internal signal processing), or may simply read or measure the input and output of the respective ECS components and assign them to the respective interfaces of the respective peripheral model. This approach simplifies the virtualization process, reduces computational complexity, and enhances the efficiency and accuracy of signal processing. For instance, by removing transient behaviors and assuming ideal conditions, the method ensures efficient signal processing, significantly improving the virtualization of ECS components compared to state-of-the-art methods. For example, a temperature sensor's output can be accurately represented and adjusted using floating-point arithmetic, while digital signals indicating the status of door locks can be processed using straightforward logical operations like AND, OR, and XOR.

Obtaining peripheral models associated with respective ECS components, where each peripheral model comprises interfaces that correspond to the respective ECS component's interfaces, ensures that the virtualization accurately reflects the physical system. Each interface of the peripheral model is associated with a signal, either analog or digital, input or output, matching the interface signal of the respective ECS component. This correspondence ensures that the virtual model or the digital twin model comprising the peripheral models can interact seamlessly with the actual ECS components, providing a reliable representation of the system.

For instance, a peripheral model for an engine control unit (ECU) would have interfaces for various sensors and actuators, such as temperature sensors and fuel injectors, matching the real ECU's interfaces. The operation of the ECS components and the internal signal processing are thereby abstracted and bypassed, with the peripheral model representing a black box in this respect. This abstraction allows for quick and efficient simulation without delving into the internal complexities of the ECS components.

The method further includes obtaining, for simulating signal processing between the peripheral models, signal operations that represent signal processing between the respective ECS components. These signal operations include logical operations for the digital signals and mathematical operations for the analog signals, thereby providing a unified framework for signal processing. For example, logical operations like AND, OR, and NOT can be used to process digital signals from a transmission control unit (TCU), while mathematical operations like addition and multiplication can be used to process analog signals from an engine control unit (ECU).

The method involves executing the signal operations to evaluate the signal processing between the ECS components. This step ensures that the interactions between different ECS components are accurately simulated and evaluated. For instance, executing signal operations can help simulate the interaction between the ABS and the traction control system (TCS), ensuring that both systems work together seamlessly to maintain vehicle stability.

The method uses said evaluation of the signal processing and/or the executed signal operations by a machine learning model to predict cascading malfunctions across multiple ECS components.

When the model uses the evaluation of signal processing, it analyzes runtime signal values-such as voltage, temperature, or control flags-generated during simulation to detect behavioral anomalies that may precede faults. When the model uses the executed signal operations, it examines the structure and logic of the signal transformations-such as nested logical expressions, operand relationships, and dependency graphs-that define how signals are processed between ECS components. This structural input is critical because it reflects the actual logic applied during simulation, not just the static definitions of operations. The term "executed signal operations" refers to the runtime-applied logic trees and their execution context, which are useful for identifying fault-prone configurations. When the model uses both inputs (evaluation of signal processing and the executed signal operations), it combines behavioral and structural insights, allowing it to detect complex failure precursors that arise from the interaction between signal values and their transformation logic. For example, in a zonal control unit managing cooling and lighting, the model may detect that a combination of high coolant temperature and inactive fan (evaluation data), coupled with a delayed activation logic in the fan control tree (executed operations), correlates with thermal overload in the power distribution module. This hybrid approach enables early, context-aware fault prediction and supports proactive adaptation before failures occur, significantly enhancing system reliability and safety.

The evaluation of the signal processing between the ECS components (in the execution step) may yield analog and/or digital signal evaluation data that reflect the dynamic behavior of the virtualized ECS under simulated conditions. These data may include computed signal values, intermediate transformation results, and time-aligned signal transitions. In addition to these evaluation results, the system may also utilize the executed signal operations themselves-including their structure, logical composition, and dependency graphs-as input for subsequent analysis. Together, these inputs form a rich representation of both the runtime behavior and the underlying logic of the ECS, enabling advanced anomaly detection and predictive diagnostics.

The machine learning model may use said evaluation of the signal processing and/or the executed signal operations to predict cascading malfunctions across multiple ECS components. The machine learning model may utilize, for instance, the analog and digital signal evaluation data to detect runtime anomalies, and the executed signal operations to identify structural or logical patterns that correlate with known failure modes. The model may be implemented as a multi-layer perceptron (MLP), a graphical neural network (GNN), or another suitable architecture capable of capturing complex interdependencies between signal sources, transformation logic, and ECS components. It may be trained offline on historical signal data, including known cascading failure patterns and normal operational sequences, enabling it to generalize to previously unseen scenarios.

The machine learning model may process both the evaluation signal data and the executed signal operations to identify patterns indicative of emerging faults or inconsistencies that may not yet have manifested as explicit malfunctions. For example, the model may detect that a specific combination of signal values-such as elevated temperature and low fan speed-combined with a particular logical structure-such as a delayed activation condition-has historically preceded thermal overload in a zonal control unit. The model may be configured to output a probability value or risk score indicating the likelihood of a cascading malfunction, wherein a fault in one component may propagate through signal dependencies or logic chains to affect other components. This predictive capability enables the system to detect latent or incipient faults that would otherwise remain undetected by rule-based or threshold-based validation methods.

For example, in a scenario involving a steering assistance system, the machine learning model may detect that a combination of fluctuating torque validity signals and inconsistent speed sensor readings correlates with a known failure mode in which the assistance level oscillates unpredictably. In this case, the model may not only rely on the signal values but also recognize that the logical structure of the assist-level computation-e.g., a nested AND operation with delayed inputs-contributes to the instability. By identifying this pattern early, the system can take preemptive action before the malfunction impacts vehicle behavior.

Method 100 further comprises adapting the ECS components that are predicted to malfunction. This adaptation may involve software-based or hardware-based corrective actions aimed at mitigating the predicted fault and maintaining system stability. Software-based adaptations may include recalibrating signal thresholds, adjusting control parameters, issuing reset commands, or rerouting signal paths to bypass affected components. Hardware-based adaptations may involve flagging components for replacement, isolating faulty sensors, or suggesting wiring repairs. The adaptation logic may be informed not only by the predicted risk score but also by the specific signal operations and component relationships involved in the anomaly.

The adaptation process may be designed to be context-aware and minimally invasive, ensuring that the ECS continues to operate reliably even in the presence of predicted faults. For instance, if a brake pressure sensor is predicted to drift beyond acceptable limits under certain thermal conditions, the system may proactively adjust the interpretation of its output or switch to a redundant sensor input, thereby preserving braking performance without requiring immediate physical intervention. If the logical structure of the signal operations is identified as contributing to the fault, the system may modify the operation tree-e.g., replacing a sensitive threshold condition with a filtered input-to stabilize behavior.

By integrating predictive analytics with real-time signal evaluation and structural analysis of executed signal operations, the invention enables a proactive and intelligent approach to ECS validation and fault management. This stands in contrast to traditional reactive methods, which often detect faults only after they have occurred and propagated. The invention thus provides a robust framework for enhancing the safety, reliability, and maintainability of complex ECS architectures, particularly in safety-critical domains such as automotive and aerospace systems.

Additionally or alternatively, the method may use the evaluation of the signal processing, without using the machine learning model, to identify malfunctions of one or more of the ECS components. By analyzing the results of the signal processing evaluation, the system may detect anomalies and identify malfunctioning components. For example, if the evaluation reveals that the brake light indicator is not responding correctly, the system can identify this as a malfunction in the brake light circuit. The method may adapt the malfunctioning ECS components to function properly, thereby ensuring continuous and reliable operation of the ECS. This can involve both software-based and hardware-based corrections. For instance, if a sensor is found to be malfunctioning, the system can recalibrate the sensor or apply a firmware update to correct the issue. If the problem is hardware-related, such as a faulty sensor, the system can suggest replacing the sensor to restore proper functionality. By abstracting and bypassing the internal signal processing of the ECS components, the method provides a quick and efficient simulation that enhances the development, testing, and validation processes.

In embodiments, the method may further comprise interpreting the analog and digital signal data using a semantic model configured to represent ECS system states and operational scenarios, and to detect semantic inconsistencies in combinations of analog and/or digital signals based on contextual rules, wherein the detected inconsistencies may be used to trigger anomaly alerts or initiate adapting the ECS components that are predicted to malfunction.

Unlike conventional ECS validation systems that rely solely on signal-level thresholds or static rule sets, the use of a semantic model introduces a context-aware reasoning layer capable of detecting inconsistencies that are not evident from signal values alone. This enables the system to identify logically invalid states-such as conflicting component activations or contradictory sensor readings-that would otherwise pass unnoticed. The technical effect is improved fault detection accuracy and earlier identification of system-level anomalies, enhancing safety and reliability in complex ECS environments.

In embodiments, the semantic model may comprise a rule-based ontology or a knowledge graph representing ECS system states and relationships between analog and digital signal conditions.

The integration of a rule-based ontology or knowledge graph into ECS simulation is novel in that it allows for structured, scalable representation of system knowledge, including component roles, signal dependencies, and operational constraints. This goes beyond traditional flat rule engines by enabling relational reasoning and hierarchical validation. The technical effect is enhanced interpretability, extensibility, and the ability to detect multi-signal inconsistencies across distributed ECS components.

In embodiments, interpreting the analog and digital signal data using the semantic model may comprise receiving the analog and digital signal data from the interfaces of the peripheral models, mapping the signal data to semantic entities representing ECS components and ECS system states, applying contextual rules to evaluate the logical coherence of the mapped entities, and generating alerts or annotations for signal combinations that violate semantic consistency.

This embodiment introduces a multi-stage semantic interpretation pipeline that transforms raw signal data into high-level system state representations. Unlike prior art that performs isolated signal checks, this method enables rule-based evaluation of system-wide coherence. The technical effect is the ability to detect and explain complex faults, such as contradictory actuator states or invalid sensor combinations, thereby improving diagnostic precision and system transparency.

In embodiments, the machine learning model may be a multi-layer perceptron (MLP) or a graphical neural network (GNN) trained on historical analog and digital signal data representing dependencies between ECS components.

The use of a GNN or MLP or any machine learning model trained on signal dependency data is novel in ECS simulation, as it allows the model to learn both temporal and structural fault patterns. Prior systems typically rely on rule-based or statistical anomaly detection. The technical effect is the ability to predict cascading failures by modeling how faults propagate through signal and component interconnections, enabling proactive fault mitigation.

In embodiments, the machine learning model may be configured to operate in a hybrid mode, comprising offline training on historical analog and digital signal data and real-time inference during simulation to emulate live prediction behavior.

Hybrid ML execution-combining offline training with real-time inference-is novel in ECS simulation contexts, where models are typically either static or post-processed. This configuration allows the system to benefit from deep learning accuracy while maintaining low-latency responsiveness. The technical effect is scalable, real-time fault prediction without compromising simulation performance or requiring continuous retraining.

In embodiments, the method may further comprise dynamically validating signal consistency during simulation by monitoring transitions of the analog and digital signal data generated in step 4, verifying that the analog signals remain within predefined valid ranges, verifying that the digital signals remain within binary states, and checking logical consistency of signal transitions between ECS components, wherein validation results may be used to support anomaly prediction in step 5 or adapting the ECS components that are predicted to malfunction in step 6.

Dynamic signal consistency validation during simulation is novel compared to static configuration checks used in conventional ECS tools. This embodiment enables real-time monitoring of signal behavior, including range violations, state instability, and inter-component logic conflicts. The technical effect is early detection of runtime anomalies and improved integration with predictive and adaptive subsystems, resulting in more robust and responsive ECS validation.

In embodiments, the signal operations obtained in step 3 may include at least one of: AND, OR, XOR, and NOT for digital signals, and at least one of: multiplication (MUL) and addition (ADD) for analog signals.

Unlike prior ECS simulation systems that often hard-code signal logic or rely on proprietary signal transformation formats, this embodiment introduces a standardized and extensible set of logical and mathematical operations for signal virtualization. The technical effect is the ability to simulate both control logic and physical signal transformations in a unified framework, enabling consistent evaluation across heterogeneous ECS components.

In embodiments, the signal operations may be implemented using prefix notation for wiring descriptions, and signal processing evaluation may be performed via pre-order traversal of a tree structure.

Prefix notation and tree-based evaluation are novel in the context of ECS signal processing, where infix logic and flat evaluation sequences dominate. This approach simplifies parsing, supports recursive evaluation, and enables modular signal logic construction. The technical effect is improved scalability, reduced parsing complexity, and enhanced support for dynamic reconfiguration of signal logic.

In embodiments, implementing the signal operations using prefix notation may comprise describing wiring of signals between the ECS components using prefix notation, parsing the prefix notation to construct a tree structure representing the signal operations, and performing signal processing evaluation via pre-order traversal of the tree structure.

This embodiment formalizes the signal wiring and evaluation process using a structured syntax and computational model. Unlike conventional ECS tools that rely on manual wiring diagrams or proprietary formats, this method enables automated parsing and evaluation of signal logic. The technical effect is consistent signal interpretation, reduced error rates in logic definition, and support for automated validation and debugging.

In embodiments, the method may further comprise performing validation checks during startup of the method or of a system executing the method, the validation checks including at least one of: syntax checks, semantic checks, compatibility checks, and consistency checks, thereby ensuring the peripheral models accurately represent the respective ECS components.

Startup validation checks are novel in ECS virtualization systems, which typically defer validation to runtime or rely on manual inspection. This embodiment introduces automated pre-simulation integrity checks that ensure model correctness before execution. The technical effect is reduced simulation failures, improved model fidelity, and faster development cycles.

In embodiments, the validation checks during startup may further comprise at least one of: performing syntax checks to ensure correct use of parentheses in the signal operations; performing semantic checks to ensure the signal operations are correct; performing compatibility checks to ensure no mixing between the analog signals group and the digital signals group; and performing consistency checks to ensure connections between the peripheral models are valid, comprising not connecting input to input or output to output.

This embodiment provides granular validation logic that addresses both syntactic and semantic correctness of signal operations and model wiring. Prior art lacks such fine-grained automated validation. The technical effect is early detection of configuration errors, prevention of invalid signal interactions, and improved robustness of the ECS simulation environment.

In embodiments, the method may further comprise processing signals between the peripheral models in a sequence to ensure updated data, including sorting nodes and edges in a graph to ensure each node is processed only after all its dependencies have been processed.

Dependency-aware signal evaluation is novel in ECS simulation, where signal updates are often performed in arbitrary or fixed sequences. This embodiment introduces topological sorting of signal operations to preserve logical causality. The technical effect is deterministic signal propagation, prevention of race conditions, and improved simulation accuracy.

In embodiments, adapting the ECS components that are predicted to malfunction may comprise software-based corrections and/or hardware-based corrections.

This embodiment introduces a dual-layer adaptation strategy that combines virtual (software) and physical (hardware) fault mitigation. Prior systems typically rely on post-failure diagnostics. The technical effect is proactive fault handling, reduced downtime, and enhanced system resilience.

In embodiments, the software-based corrections may comprise at least one of: recalibration by adjusting software parameters associated with the ECS components that are predicted to malfunction to correct minor deviations of the components' output; firmware updates by applying updates to fix software bugs or improve performance; and reset commands by sending reset commands to reinitialize the ECS components that are predicted to malfunction.

This embodiment formalizes software-level fault mitigation actions within the ECS virtualization framework. Unlike prior art that treats software faults as external to simulation, this method integrates correction logic directly into the simulation loop. The technical effect is seamless recovery from predicted faults and improved simulation continuity.

In embodiments, the hardware-based corrections may comprise at least one of: signal rerouting comprising sending signals to bypass the ECS components that are predicted to malfunction; component replacement comprising identifying a need for physical replacement of faulty sensors or actuators and sending feedback to a user; and wiring repairs comprising detecting and suggesting repairs for damaged or corroded wiring inside and/or outside the ECS components that are predicted to malfunction.

This embodiment extends ECS simulation to include actionable hardware-level diagnostics and adaptation. Prior systems typically stop at fault detection without suggesting physical interventions. The technical effect is improved fault traceability, support for predictive maintenance, and enhanced integration between simulation and real-world servicing workflows.

In embodiments, the logging interface may be configured to support multiple interchangeable backends, including a basic logging backend for raw signal capture, a historical data backend for time-series analysis, and a machine learning backend for predictive analytics.

This embodiment introduces a modular and extensible logging architecture that supports multiple backend types, each tailored to a specific analysis purpose. Unlike conventional ECS systems that rely on fixed or monolithic logging mechanisms, this approach allows dynamic switching between logging modes without altering the core simulation logic. The technical effect is enhanced flexibility, improved integration with analytics workflows, and support for both low-level debugging and high-level predictive diagnostics.

In embodiments, the logging interface may be further configured to capture and timestamp intermediate signal transformation results between ECS components.

Capturing and timestamping intermediate signal transformation results is novel in ECS simulation environments, which typically log only final outputs or raw inputs. This embodiment enables fine-grained traceability of signal logic execution, allowing developers to inspect and analyze the internal stages of signal processing. The technical effect is improved debugging accuracy, enhanced transparency of signal logic, and better support for anomaly localization and root-cause analysis.

In embodiments, the system may be configured to generate a visual representation of the signal flow and validation results, including highlighting inconsistent or anomalous signal paths and annotating signal nodes with validation status and predicted failure probabilities.

This embodiment introduces a visualization layer that graphically represents signal logic, validation outcomes, and predictive risk assessments. Prior ECS tools typically rely on textual logs or tabular reports. The technical effect is improved interpretability, faster fault diagnosis, and enhanced usability for developers and safety engineers, particularly in complex ECS configurations with many interdependent components.

In embodiments, the system may be integrated into a continuous integration (CI) or hardware-in-the-loop (HiL) testing pipeline to automatically validate ECS configurations during development.

Integrating ECS virtualization into CI and HiL pipelines is novel in that it enables automated, real-time validation of control logic and signal behavior as part of the development lifecycle. Traditional ECS validation is often manual or post-deployment. The technical effect is early fault detection, reduced regression risk, and streamlined certification processes, thereby improving development efficiency and system reliability.

According to another aspect of the invention, there is provided a system for virtualizing and electronic control system, ECS, comprising: a signal abstraction module (210) configured to abstract signals in ECS components (202), comprising categorizing said signals into categorized groups, including analog signals group (215) and digital signals group (220), thereby facilitating distinct processing paths for different signal groups; a standardized interface module (203) configured to encapsulate peripheral models (204) with respective ECS components (202), each peripheral model comprising interfaces that correspond to respective interfaces of the respective ECS component, each interface of the peripheral model being associated with a signal, which is an analog signal or a digital signal, an input signal or an output signal, matching an interface signal of the respective ECS component; a signal operations module (225) configured to obtain, for simulating signal processing between the peripheral models (205), signal operations that represent signal processing between the respective ECS components, said signal operations including logical operations (230) for the digital signals, and mathematical operations (235) for the analog signals, thereby providing a unified framework for signal manipulation; a signal evaluation module (240) configured to execute the signal operations (230, 235) to evaluate the signal processing between the ECS components; a prediction module (245) comprising a machine learning model configured to use said evaluation of the signal processing and/or the executed signal operations to predict cascading malfunctions across multiple ECS components; and a component adaptation module (250) configured to adapt the ECS components that are predicted to malfunction, thereby ensuring continuous and reliable operation of the ECS.

The system for virtualizing an electronic control system (ECS) as described is novel over prior art as it integrates a modular, multi-layered architecture that combines signal abstraction, standardized peripheral interfacing, structured signal logic execution, predictive machine learning, and adaptive fault handling-all within a unified simulation framework. Unlike conventional ECS simulation tools that typically focus on static configuration validation or isolated signal emulation, this system introduces a dynamic and intelligent virtualization environment capable of modeling both signal behavior and logical structure, predicting cascading malfunctions using evaluation data and/or executed signal operations, and proactively adapting components before faults manifest. The inclusion of a machine learning module that operates on both runtime signal evaluations and structural logic trees, combined with a component adaptation module, enables real-time fault anticipation and mitigation, which is not found in traditional ECS modeling platforms.

An example implementation of this system in a zone control unit (ZCU) may involve a front-zone ECS managing lighting, radar, cooling, and power distribution. The signal abstraction module categorizes inputs such as ambient_light_level, radar_range, and coolant_temperature into analog and digital groups. Peripheral models for the headlight controller, radar sensor, and fan actuator are encapsulated via standardized interfaces. Signal operations like headlight_trigger = AND(vehicle_speed > 0, ambient_light_level < 400) and cooling_demand = MUL(coolant_temperature, thermal_coefficient) are executed and evaluated. The machine learning model, trained on historical ZCU data, detects that a combination of high temperature and inactive fan correlates with thermal overload in the power distribution module. The adaptation module responds by activating the fan and flagging the coolant sensor for inspection. This implementation demonstrates how the system enables predictive, context-aware, and modular ECS simulation and fault management in a real-world zonal architecture.

According to another aspect of the present disclosure, there is provided a computer program comprising instructions which, when the computer program is executed by a computer, cause the computer to carry out the methods discussed above.

According to another aspect of the present disclosure, there is provided a computer-readable data carrier having stored thereon the computer program disclosed above.

According to another aspect of the present disclosure, there is provided an apparatus comprising: one or more interfaces for communication; a memory; and a data processing circuit configured to carry out any one of the method described above.

Examples will now be further described with reference to the figures in which:
Fig. 1 shows a flow diagram illustrating a computer-implemented method 100 for virtualizing an electronic control system.
Fig. 2 shows a schematic illustrating the system used for virtualizing an electronic control system according to method 100.
Fig. 3 schematically illustrates a block diagram of an embodiment of an apparatus to execute the methods described herein.

### Detailed Description

The present invention may provide a system and method for virtualizing an electronic control system (ECS), enabling simulation, validation, and predictive analysis of signal processing across multiple interconnected ECS components. The invention may be particularly suited for complex embedded systems, such as those found in automotive, aerospace, or industrial automation domains, where safety, reliability, and real-time behavior are critical.

The method may begin by abstracting the technical details of signals in ECS components. This abstraction may involve categorizing signals into distinct groups, including an analog signals group and a digital signals group. Such categorization may facilitate distinct processing paths for different signal types, allowing the system to apply tailored operations to each group. For instance, analog signals may be represented as floating-point values to support precise mathematical operations, while digital signals may be simplified to binary states to enable efficient logical processing. This abstraction may also include reducing complex signal types, such as pulse-width modulation (PWM) signals, to scalar representations like duty cycles, thereby avoiding the need to simulate transient behaviors.

The abstraction process may further simplify the ECS model by focusing on input-output behavior rather than internal component logic. Peripheral models may be constructed to represent ECS components as black boxes, with interfaces that match the real components' signal characteristics. These peripheral models may be obtained and associated with respective ECS components, each comprising input and output interfaces that correspond to the actual hardware interfaces. Each interface may be linked to a signal, which may be analog or digital, and may represent either an input or output. This modeling approach may ensure that the virtualized ECS accurately reflects the structure and behavior of the physical system while maintaining computational efficiency.

Once the peripheral models are established, the method obtains signal operations that represent the signal processing logic between the ECS components. These operations may include logical operations such as AND, OR, XOR, and NOT for digital signals, and mathematical operations such as addition and multiplication for analog signals. The signal operations may be expressed in a structured format, such as prefix notation, to enable efficient parsing and evaluation. The operations may be organized into tree structures, and signal processing evaluation may be performed using pre-order traversal of these trees, allowing for modular and scalable computation.

The execution of the signal operations may simulate the dynamic behavior of the ECS under various conditions. This execution may generate analog and digital signal data that reflect the internal state transitions and inter-component interactions within the virtualized system. These data may be continuously monitored and analyzed to detect inconsistencies, anomalies, or deviations from expected behavior.

To enhance the robustness of the system, the invention incorporates a machine learning model configured to process the evaluated analog and digital signal data. The model may be trained on historical ECS signal data, including both normal and faulty operational patterns. It may be implemented using architectures such as multi-layer perceptrons (MLPs), graphical neural networks (GNNs), or other suitable models capable of capturing temporal and structural dependencies between signals and components.

The machine learning model is configured to predict cascading malfunctions across multiple ECS components. It may analyze the signal data to identify patterns that precede known failure modes, including those that involve interdependent signal inconsistencies or state transitions. The model may output a probability value or risk score indicating the likelihood of a cascading failure, and may trigger alerts or initiate mitigation strategies when the predicted risk exceeds a predefined threshold.

Based on the predicted anomalies, the system adapts the ECS components that are predicted to malfunction. This adaptation may be performed through software-based or hardware-based corrective actions. Software-based adaptations may include recalibrating signal thresholds, modifying control logic parameters, issuing reset commands, or rerouting signal paths to bypass affected components. Hardware-based adaptations may involve isolating faulty sensors, suggesting component replacements, or identifying wiring faults for repair. These adaptations may be applied proactively, before the predicted malfunction manifests, thereby ensuring continuous and reliable operation of the ECS.

The system may further support dynamic signal consistency validation during simulation. This may include monitoring transitions of analog and digital signal data, verifying that analog signals remain within predefined physical ranges, and ensuring that digital signals maintain valid binary states. Logical consistency between signals exchanged across ECS components may also be checked to detect contradictions or invalid state transitions. These validation results may be used to support the machine learning model's predictions or to directly trigger adaptation mechanisms. To ensure correctness from the outset, the system may perform validation checks during startup. These checks may include syntax validation of signal operation expressions, semantic validation of signal logic, compatibility checks to prevent mixing of analog and digital signal types, and consistency checks to ensure valid wiring configurations between peripheral model interfaces. For example, the system may detect and flag invalid connections such as input-to-input or output-to-output links.

Signal processing between peripheral models may be performed in a dependency-aware sequence. The system may construct a directed graph of signal dependencies and sort the nodes and edges to ensure that each signal is evaluated only after all its input dependencies have been resolved. This topological ordering may prevent race conditions and ensure deterministic simulation behavior.

The system may also support a modular logging interface, allowing for interchangeable backends. These may include a basic logging backend for raw signal capture, a historical data backend for time-series analysis, and a machine learning backend for predictive analytics. The logging interface may be further configured to capture and timestamp intermediate signal transformation results, enabling fine-grained traceability and post-simulation analysis.

To enhance usability and transparency, the system may generate visual representations of the signal flow and validation results. These visualizations may highlight inconsistent or anomalous signal paths and annotate signal nodes with validation status and predicted failure probabilities. Such visual feedback may assist developers in debugging, tuning, and certifying ECS behavior.

Finally, the system may be integrated into continuous integration (CI) pipelines or hardware-in-the-loop (HiL) testing environments. This integration may enable automated validation of ECS configurations during development, ensuring that signal-level correctness, consistency, and safety are maintained throughout the software lifecycle.

Through the combination of signal abstraction, modular peripheral modeling, formalized signal operations, dynamic validation, predictive machine learning, and adaptive fault mitigation, the invention may provide a comprehensive and scalable framework for virtualizing and validating electronic control systems. This approach may significantly improve the reliability, safety, and maintainability of complex ECS architectures, particularly in domains where real-time correctness and fault tolerance are paramount.

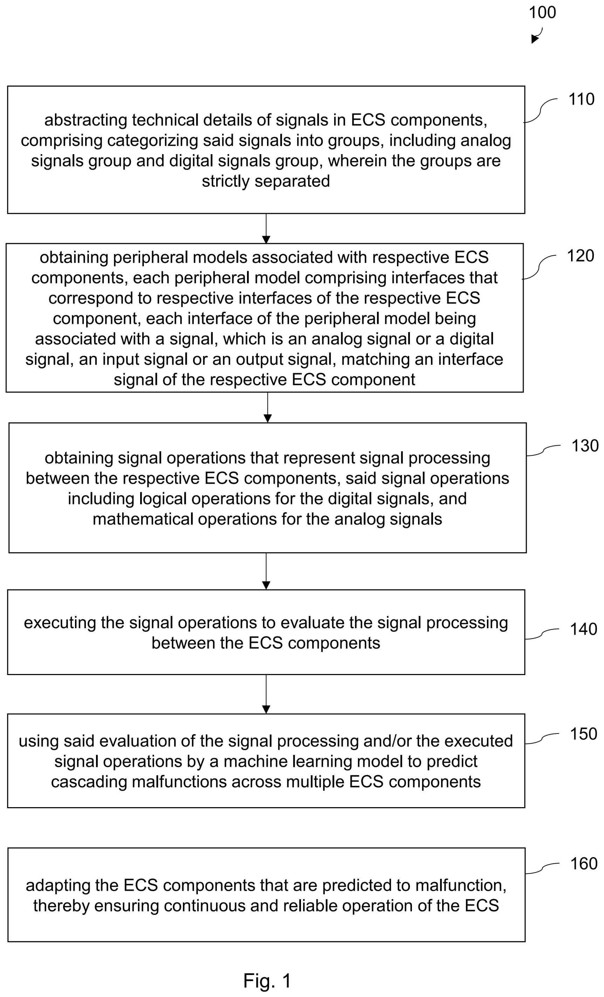

Fig. 1 shows a flow diagram illustrating a computer-implemented method 100 for virtualizing an electronic control system.

Step 110 of method 100 comprises abstracting technical details of signals in ECS components, comprising categorizing said signals into groups, including analog signals group and digital signals group, thereby facilitating distinct processing paths for different signal groups.

In embodiments, the groups may be strictly separated. In embodiments the analog signals may comprise continuous signals, for instance at least one of voltage signals and current signals. The digital signals may comprise discrete signal, for instance at least one of digital input/output, DIO, signals and pulse width modulation PWM signals.

In the context of automotive systems, an ECS refers to a comprehensive framework that manages and controls various electronic components and subsystems within an electric vehicle. The ECS may be responsible for ensuring the efficient and coordinated operation of these components, which include sensors, actuators, and control units. For example, an ECS might manage the vehicle's battery management system (BMS), which includes components such as voltage sensors, current sensors, and thermal sensors. By monitoring and adjusting the performance of these components, the ECS helps to optimize battery performance and ensure safety.

An Electronic Control Unit (ECU), also known as an electronic control module (ECM), is an embedded system within automotive electronics that controls one or more of the electrical systems or subsystems in a vehicle. Modern electric vehicles are equipped with numerous ECUs, each dedicated to specific functions. Examples of ECUs include the motor control unit (MCU), which manages the performance of the electric motor; the battery management system (BMS), which oversees the operation and health of the battery pack; and the power electronics controller (PEC), which regulates the flow of electrical energy between the battery and the motor.

These ECUs work together to ensure the vehicle operates smoothly and efficiently under various driving conditions.

The components of an ECU in electric vehicles are critical for its operation and functionality. Key components include the microcontroller, which serves as the central processing unit; memory components such as SRAM, EEPROM, and Flash, which store data and software; and various input and output interfaces. The ECU collects data from sensors placed throughout the vehicle, such as voltage sensors, current sensors, and temperature sensors. It processes this data in real-time to make adjustments to parameters such as motor speed, battery charging and discharging rates, and thermal management, to optimize performance and ensure safety. Additionally, the ECU communicates with other control units in the vehicle, such as those responsible for regenerative braking and climate control, to coordinate vehicle responses and enhance efficiency and performance.

An Electronic Control System (ECS) according to the present disclosure can also function as a zone control unit (ZCU) in electric vehicles. A zone control unit consolidates various functions within specific physical zones of the vehicle, streamlining communication and power distribution. For example, a zone control unit might manage the functions of the vehicle's front zone, including components such as the front lighting system, front sensors (e.g., radar and lidar for advanced driver-assistance systems), and the front power distribution module. By localizing control within specific zones, the ZCU reduces wiring complexity, enhances system efficiency, and facilitates easier integration of new technologies. This zonal architecture supports the transition towards more centralized and scalable vehicle electronic systems, ultimately contributing to the development of software-defined vehicles.

The virtualization method described herein offers significant advantages for both ECUs and ZCUs by abstracting and simplifying the technical details of their components. By abstracting real-world signal properties, such as ignoring transient behaviors, assuming ideal physical conditions, and representing signal values in simplified forms (e.g., floating-point for voltage/current, binary for DIO, and percentage for PWM duty cycles), the method reduces complexity and facilitates easier analysis. This approach enables more efficient signal processing and integration of new technologies. For ECUs, it improves performance and reliability through streamlined software updates and recalibrations. For ZCUs, it reduces wiring complexity and enhances system scalability, allowing for more centralized control and easier maintenance. Overall, this abstraction and simplification facilitate continuous monitoring and optimization, ensuring that both ECUs and ZCUs operate effectively and adapt to evolving vehicle requirements.

Step 120 of method 100 comprises obtaining peripheral models associated with respective ECS components, wherein each peripheral model comprises interfaces that correspond to respective interfaces of the respective ECS component, each interface of the peripheral model being associated with a signal, which is an analog signal or a digital signal, an input signal or an output signal, matching an interface signal of the respective ECS component.

In embodiments, said signal may be acquired from the respective interface of the respective ECS component, meaning that the signal may be directly obtained from the physical interface where the ECS component connects to the respective peripheral models. This acquisition can occur in various ways, such as through direct measurement of electrical signals (e.g., voltage or current) at the interface, digital data retrieval from communication protocols (e.g., CAN bus, LIN bus), and/or sensor readings from connected devices. For example, in an Anti-lock Braking System (ABS), the wheel speed sensor's signal is acquired directly from the sensor's interface, which measures the rotational speed of the wheel and sends this data to the ABS controller. This direct acquisition ensures that the peripheral model accurately reflects the real-world signal characteristics, enabling precise simulation and analysis.

In embodiments, each interface may be designated as either input interface or output interface matching the interface of the respective ECS component. I embodiments, the input interface may be a read-write interface and the output interface may be a read-only interface.

In embodiments each peripheral model is assigned a number of interfaces equal to or corresponding to the number of interfaces of the respective ECS component. In embodiments, the assigned number of interfaces corresponding to the interfaces of the respective ECS component may be equivalent to the number of pins of said ECS component, each interface of the peripheral model may be associated with a signal, the signal may be an analog signal (e.g. voltage, current) or a digital signal (e.g. DIO, PWM), each itnerface may be identified by a unique name, and each interface may be designated as either input (e.g. read-write) or output (e.g. read-only). This structured approach ensures that the peripheral models accurately reflect the real-world ECS components, facilitating seamless integration and testing within the virtual environment.

In other embodiments, the peripheral models In embodiments, the peripheral models may be black box models wherein only the connections between said models represent the connections between the respective ECS components. In embodiments, the peripheral models can be obtained using various techniques such as software code, simulation, and artificial intelligence including machine learning algorithms. For instance, software code can be used to define the behavior and interfaces of the peripheral models. Simulation tools, like SystemC or MATLAB/Simulink, can be employed to model and test the peripherals in a virtual environment. AI techniques can also be utilized to optimize the design and functionality of the peripheral models by analyzing large datasets and learning from them.

An example of a model peripheral is a Battery Management System (BMS) in an electric vehicle. The BMS peripheral model would include interfaces corresponding to the actual BMS component, such as voltage sensors, current sensors, and thermal sensors. Each interface (or pin) would be associated with a specific signal type or group, such as analog signals for voltage and current, and digital signals for status indicators (e.g., DIO, PWM). Each pin would be uniquely named and designated as either input (read-only) or output (read-write), ensuring accurate representation and interaction within the virtual ECS.

Additionally or alternatively, according to the present disclosure, the peripheral models can be created without using any algorithms. The peripheral models may be developed by simply abstracting the function or signal processing of the corresponding ECS component and using logical functions to simulate them, for instance, or simply replicating the input signals and outputs signals of the ECS components to the respective peripheral models, as described herein in the following steps of method 100. For example, a peripheral model for a temperature sensor could either measure the input output reading and assign it to the respective peripheral model, or may be created by abstracting its function to generate a temperature reading based on predefined conditions and using logical functions to simulate its behavior in response to changes in the environment. This approach simplifies the creation of peripheral models, making it accessible and efficient while still providing accurate and useful simulations for the ECS.

Step 130 of method 100 comprises obtaining, for simulating signal processing between the peripheral models, signal operations that represent signal processing between the respective ECS component, said signal operations including logical operations for the digital signals, and mathematical operations for the analog signals, thereby providing a unified framework for signal manipulation.

In embodiments, the logical operations may include at least one of: including AND, OR, XOR, and NOT for the digital signals. The mathematical operations may include at least one of multiplication, MUL, and addition, ADD, division, DIV, and subtraction, SUB.

The step of obtaining signal operations for simulating signal processing between the peripheral models may involve creating a set of operations that abstract or virtualize the signal processing between the respective ECS components. These signal operations may include logical operations for digital signals and mathematical operations for analog signals, providing a unified framework for signal processing. Said signal operations may represent the flow of signals or the signal processing between said ECS components, said signal operations may not replicate each single operation inside the ECS component. Instead, they either simplify the input-output relationship, replicating the output as a function of the input, or they read, measure, map and/or replicate the input signals at respective input interfaces of the respective peripheral models, and/or they read, measure, map and/or replicate the output signals at respective output interfaces of the respective peripheral models.

According to the disclosed method, the signal operations may abstract the (e.g. complex) internal signal-processing or processes of the ECS components into simplified input-output operations, or may simply read or measure the input and output signals of the ECS components and assign them to the respective peripheral models, thereby making the peripheral model as a black box. This means that instead of modeling every internal detail of the component, the virtual system of the method may either focus on the relationship between the inputs and the resulting outputs, or may simply read and replicate the input and output signals of the ECS components to the respective peripheral models. This approach reduces complexity and quickly identifies malfunctions in the real-world ECS components.

In the context of quick and efficient malfunction detection, the method can be applied to the Battery Management System (BMS) of electric vehicles. The BMS receives inputs such as voltage and current measurements from individual battery cells and provides outputs like State of Charge (SOC) and State of Health (SOH) indicators. For analog operations, the method uses mathematical operations to process these inputs. For instance, averaging the voltage and current values can determine the overall state of the battery pack. An example averaging operation might be: SOC = AVG(Voltage, Current). This operation abstracts the detailed electrochemical processes within the battery cells, focusing instead on the input measurements to provide a simplified and essential output for monitoring the battery pack.

For digital operations, the method employs logical operations to detect malfunctions. For example, a logical operation can determine if any cell voltage exceeds safe limits, triggering a warning signal. An example operation might be: Warning = OR(Voltage1 > Threshold, Voltage2 > Threshold). This operation checks if either of two voltage readings (Voltage1 or Voltage2) exceeds a safe limit (Threshold). If either voltage is too high, the system triggers a warning. This helps quickly identify potential issues for further investigation. For example, in a Battery Management System (BMS), if any battery cell voltage exceeds the safe limit, the system alerts to prevent damage or hazards. This operation simplifies the detection of potential issues by focusing on critical thresholds, ensuring that any deviations are quickly identified and flagged for further investigation.

By abstracting the complex internal signal processing and focusing on the input-output relationships, the method enables efficient and accurate malfunction detection. This approach ensures that the BMS can quickly identify and respond to potential issues, maintaining the reliability and safety of the electric vehicle.

In another embodiment, in the context of quick and efficient malfunction detection, the method can be applied to the BMS of electric vehicles. The BMS receives inputs such as voltage and current measurements from individual battery cells and provides outputs like State of Charge (SOC) and State of Health (SOH) indicators. For analog operations, the method may passively replicate the measured input values and output values at respective pins of the ECS components and replicates them to the respective input and output of the respective peripheral models. For instance, the voltage and current values from the battery cells are directly replicated to the peripheral model without any internal processing. This passive replication abstracts the detailed electrochemical processes within the battery cells, focusing instead on the input measurements to provide a simplified and essential output for monitoring the battery pack.

For digital operations, the method employs logical operations to detect malfunctions. For example, a logical operation can determine if any cell voltage exceeds safe limits, triggering a warning signal. An example operation might be: Warning = OR(Voltage1 > Threshold, Voltage2 > Threshold). This operation simplifies the detection of potential issues by focusing on critical thresholds, ensuring that any deviations are quickly identified and flagged for further investigation. By passively replicating the digital input values and output values at respective pins of the ECS components to the respective input and output of the peripheral models, the method abstracts the complex internal signal processing and focuses on the input-output relationships. This approach ensures that the BMS can quickly identify and respond to potential issues, maintaining the reliability and safety of the electric vehicle.

In another embodiments, in the context of quick and efficient malfunction detection, the method can be applied to the Motor Controller Unit (MCU) of electric vehicles. The MCU receives inputs such as throttle position (a digital input/output (DIO) signal) and battery voltage (an analog signal) and provides outputs like motor speed (a pulse width modulation (PWM) signal) and torque (an analog signal). For analog operations, the method may passively replicate the measured input values and output values at respective pins of the ECS components and replicates them to the respective input and output of the respective peripheral models. For instance, the throttle position and battery voltage values are directly replicated to the peripheral model without any internal processing.

For digital operations, the method may employ logical operations to detect malfunctions. For example, a logical operation can determine if the battery voltage is above a minimum threshold, ensuring safe operation. An example operation might be: Motor Speed = AND(Throttle Position, Battery Voltage > Min Voltage). This operation simplifies the detection of potential issues by focusing on critical thresholds, ensuring that any deviations are quickly identified and flagged for further investigation. By passively replicating the digital input values and output values at respective pins of the ECS components to the respective input and output of the peripheral models, the method abstracts the complex internal signal processing and focuses on the input-output relationships. This approach ensures that the MCU can quickly identify and respond to potential issues, maintaining the reliability and safety of the electric vehicle.By abstracting the signal operations to simplified input-output relationships, the system can efficiently virtualize and process signals from various ECS components. This approach reduces complexity, enhances scalability, and ensures accurate simulation and control of the ECS components in electric vehicles. The examples provided illustrate how different ECS components and their connections can be effectively managed using this method.

Step 140 of method 100 comprises executing the created signal operations to evaluate the signal processing between the ECS components.

This step applies the defined logical operations (e.g., AND, OR, XOR, NOT) to digital signals and mathematical operations (e.g., multiplication (MUL), addition (ADD)) to analog signals. By doing so, the method can process and analyze the signals in a structured manner, ensuring accurate evaluation of the ECS components' performance. This implementation allows for the detection of anomalies or malfunctions by comparing the processed signals against expected values, thereby facilitating timely adjustments and maintenance.

For example, consider a scenario where the ECS includes a Transmission Control Unit (TCU) and an Engine Control Unit (ECU). The TCU sends a digital signal indicating the current gear position, which is processed using logical operations. If the TCU sends a signal indicating that the vehicle is in "Drive" (represented by a digital signal), the logical operation AND can be used to combine this signal with another digital signal from the brake pedal sensor. The combined signal ensures that the vehicle can only start if both the gear is in "Drive" and the brake pedal is pressed. This logical operation ensures safety by preventing the vehicle from starting in an incorrect gear.

In the context of an electric car, a Zonal Control Unit (ZCU) serves as an example of how this step is applied. A ZCU manages various functions within a specific zone of the vehicle, such as the front or rear zone. For instance, in the front zone, the ZCU might handle the integration and control of components like the front lighting system, radar and lidar sensors for advanced driver-assistance systems (ADAS), and the front power distribution module. By abstracting the ZCU components into corresponding peripheral components, as explained above, and executing the created signal operations to the peripheral components, the method can evaluate the signals from these components, ensuring they operate correctly and efficiently. For example, the method can process signals from the radar sensors to detect obstacles and adjust the vehicle's speed or direction accordingly. Similarly, it can evaluate the signals from the lighting system to ensure proper illumination based on driving conditions. This structured evaluation process enhances the overall performance and reliability of the electric vehicle's electronic systems.

Step 150 of method 100 comprises using the evaluation of the signal processing and/or the executed signal operations by a machine learning model to predict cascading malfunctions across multiple ECS components.

This step introduces a predictive intelligence layer into the ECS virtualization framework. The machine learning model may operate on one or more types of input derived from the simulation process. These inputs may include (i) the evaluation data generated in Step 140 - such as the results of executing signal operations between peripheral models, including analog and/or digital signal values, intermediate transformation outputs, and derived indicators of component behavior - and/or (ii) the executed signal operations themselves, which may represent the logical and mathematical relationships between signals, including their structure, dependencies, and transformation logic.

By analyzing the evaluation data, the machine learning model may detect runtime anomalies, such as signal values that deviate from expected ranges or exhibit unusual temporal patterns. By analyzing the executed signal operations, the model may learn structural or topological patterns in the ECS configuration that are statistically correlated with failure propagation, such as deeply nested logic trees, circular dependencies, or high fan-in/fan-out signal paths.

The model may be trained offline using historical ECS datasets that include examples of both nominal and faulty system behavior. These datasets may contain annotated signal evaluations and corresponding signal operation structures, enabling the model to learn both behavioral and architectural indicators of risk. During simulation, the trained model may operate in real time, continuously ingesting the evaluation data and/or executed signal operations and computing a probability score or risk metric for each ECS component or subsystem.

This score may quantify the likelihood of a malfunction occurring, particularly in the form of cascading failures - where a fault in one component leads to a chain reaction affecting other components due to signal interdependencies. The model may also identify latent vulnerabilities in the ECS configuration that, while not immediately causing faults, may increase the system's susceptibility to failure under specific conditions.

For example, in a vehicle's steering assistance system, the evaluation data may indicate that the torque validity signal fluctuates due to inconsistent sensor fault flags across two ECUs. Simultaneously, the executed signal operations may reveal that the assist level computation depends on a conjunction of these inconsistent signals. The machine learning model may recognize this combination - both in terms of signal behavior and logical structure - as a known precursor to unstable assist level switching. It may therefore predict a high risk of a cascading malfunction involving both the torque computation logic and the actuator control path.

By leveraging the evaluation of signal processing and the structure of executed signal operations, the machine learning model may provide a comprehensive, context-aware prediction of system-level anomalies. This approach may enable the ECS virtualization system to anticipate faults that are data-driven and structurally induced, thereby supporting proactive fault management and enhancing the overall reliability, safety, and maintainability of the ECS.

In embodiments, the evaluation of the signal processing may refer to the computed results obtained by executing signal operations between ECS components during simulation. These results may include analog and/or digital signal values, intermediate transformation outputs, and derived metrics that reflect the dynamic behavior of the ECS under simulated conditions. The evaluation may be time-aligned and context-sensitive, capturing how signals evolve across simulation cycles. In alternative formulations, this may be described as signal output data, runtime signal state, or processed signal traces. For example, in a zonal control unit managing cooling and lighting, the evaluation may include values such as cooling_demand = 68.4 and headlight_trigger = 1, derived from mathematical and logical operations applied to sensor inputs and control flags. These evaluated results serve as input to the machine learning model for anomaly detection and predictive diagnostics.

In embodiments, the executed signal operations may refer to the logical and mathematical expressions applied to signals during simulation, including their structure, operand relationships, and transformation logic. These operations may be represented in prefix notation and organized into tree structures or directed acyclic graphs (DAGs), enabling recursive evaluation. In alternative formulations, this may be described as signal logic trees, operation graphs, or signal transformation schemas. For example, the operation AND(NOT(sensor_fault), speed_ok) may be executed to determine whether torque assistance should be enabled. The structure and composition of such operations-independent of their evaluated output-may be used by the machine learning model to identify patterns of logic complexity, dependency depth, or fault-prone configurations that correlate with cascading malfunctions. This structural input complements the evaluation data and enhances the model's ability to generalize across ECS architectures.

The machine learning model used in the present invention may be implemented as a supervised or semi-supervised learning system configured to predict cascading malfunctions across multiple ECS components. The model may be designed to process structured input data derived from the virtualized ECS simulation, including the evaluation of signal processing results and/or the executed signal operations between peripheral models.

The input to the model may include, but is not limited to: (i) analog and/or digital signal evaluation data resulting from the execution of signal operations, such as time-series values, signal transitions, and derived metrics; and (ii) representations of the executed signal operations themselves, including logical and mathematical operation trees, signal dependency graphs, and transformation sequences. These inputs may be encoded into numerical feature vectors or graph-based structures suitable for ingestion by the model.

The machine learning model may be trained offline using a dataset comprising historical ECS simulation logs, real-world operational data, or synthetically generated fault injection scenarios. Each training sample may include a sequence of signal evaluation data and/or signal operation structures, annotated with labels indicating the presence or absence of cascading malfunctions, the affected components, and the severity or propagation path of the fault.

Training may be performed in mini-batches using stochastic gradient descent or a variant thereof, such as Adam or RMSProp. Each batch may consist of multiple simulation traces, where each trace represents a time-aligned sequence of signal evaluations and corresponding ECS states. The model may be optimized to minimize a loss function that penalizes incorrect predictions of fault likelihood, misclassification of affected components, or inaccurate estimation of failure propagation.

In one embodiment, the model may be a multi-layer perceptron (MLP) with fully connected layers and nonlinear activation functions, trained to map input features to a scalar risk score. In another embodiment, the model may be a graphical neural network (GNN) that operates on a graph representation of the ECS, where nodes correspond to components or signals and edges represent signal dependencies or logical connections. The GNN may learn to propagate information across the graph to infer the likelihood of cascading effects.

During the inference phase, the trained model may be deployed within the ECS virtualization environment. As the simulation executes and signal operations are evaluated, the system may continuously collect evaluation data and/or executed operation structures. These inputs may be preprocessed and fed into the model in real time or near-real time. The model may output a probability value or risk score for each ECS component, indicating the likelihood of an impending malfunction or cascading failure.

The output of the model may be used to trigger alerts, log anomaly events, or initiate adaptation mechanisms as described in Step 160. For example, if the model predicts a high risk of failure in a braking subsystem due to a combination of signal inconsistencies and structural dependencies, the system may proactively adjust control parameters, reroute signals, or isolate the affected component to maintain safe operation.

The machine learning model may be periodically retrained or updated using newly collected simulation data or field data, allowing it to adapt to evolving system configurations, new failure modes, or updated component models. This continuous learning capability may enhance the model's accuracy and robustness over time, ensuring that the ECS virtualization system remains effective in detecting and mitigating faults in increasingly complex control architectures.

Consider a virtualized electronic control system (ECS) comprising three interconnected components: a Brake Control Module (BCM), a Wheel Speed Sensor (WSS), and an Electronic Stability Control Unit (ESC). During simulation, signal operations are executed between these components. For example, the WSS provides analog signals representing wheel rotational speed, which are processed by the BCM to compute braking force. The ESC receives both the braking force and lateral acceleration data to determine whether to activate stability correction.

In Step 140, the system executes signal operations such as: brake _force = MUL(wheel_speed, brake_pedal_position), and stability_trigger = AND(brake_force > threshold, lateral_accel > limit). These operations are evaluated over time. Suppose that during a simulation run, the following evaluation data are generated over a 5-second window at 100 Hz sampling: wheel_speed (analog): [52.3, 51.8, 51.2, 50.7, 50.1, ..., 45.0] km/h; brake_pedal_position (analog): [0.0, 0.1, 0.3, 0.6, 0.9, ..., 1.0] (normalized); brake _force (computed): [0.0, 5.18, 15.36, 30.42, 45.09, ..., 45.0]; lateral_accel (analog): [0.2, 0.3, 0.5, 0.7, 0.9, ..., 1.2] g; stability_trigger (digital): [0, 0, 0, 1, 1, ..., 1]. These evaluated signals are collected and passed to the machine learning model in Step 150. Additionally, the executed signal operations - including the structure of the logic trees and the dependencies between wheel_speed, brake_pedal_position, and lateral_accel - may be encoded as a graph structure and also provided as input.

The machine learning model in Step 150, trained on historical ECS simulation data, recognizes that a rapid increase in brake _force combined with high lateral acceleration and a persistent stability_trigger signal has historically preceded hydraulic actuator overheating in the ESC unit. The model computes a risk score of 0.87 (on a scale from 0 to 1) for the ESC component, indicating a high likelihood of a cascading malfunction.

This prediction in Step 150 is made before any actual fault occurs in the simulation. The model's inference is based not only on the signal values but also on the structure of the signal operations, which reveal that the ESC's decision logic is tightly coupled to two rapidly changing inputs without damping or delay compensation.

As a result, the system may log the anomaly, issue a warning, and prepare to adapt the ESC component in Step 160 - for example, by reducing the sensitivity of the stability_trigger logic or simulating a fallback mode that limits actuator duty cycle. This example illustrates how the machine learning model may use both evaluated signal data and executed signal operations to predict cascading malfunctions in a proactive and context-aware manner, enabling early intervention and enhancing system resilience.

As used in Step 150 of the present invention, the term cascading malfunction refers to a fault condition in which a malfunction in one ECS component leads to secondary or tertiary faults in other components due to signal dependencies, logical coupling, or shared operational context. This differs from isolated component failures, which are addressed in conventional ECS validation systems. Cascading malfunctions may arise, for example, when a cooling fan relay fails to activate, resulting in thermal overload in the power distribution module, which in turn causes voltage instability affecting the lighting system. In another scenario, a misinterpreted radar fault flag may suppress activation of the emergency braking system, leading to delayed collision mitigation. The machine learning model disclosed herein may be trained to detect such cascading patterns by ingesting historical signal evaluation data and executed signal operations, including for instance the structure of logical dependencies and timing relationships. Training data may include labeled sequences of signal transitions and component states that precede known multi-component failures. By learning both behavioral and structural precursors to cascading faults, the model can generalize to unseen configurations and predict system-wide risks before they manifest, enabling proactive adaptation and fault containment. This capability represents a substantial technical improvement in ECS reliability and safety.

Additionally or alternatively, Step 150 of method 100 may comprise using said evaluation of the signal processing to identify malfunctions of one or more of the ECS components.

By analyzing the processed analog and digital signals and the evaluation of the signal processing, without using a machine learning model, the system can detect deviations from expected values or patterns that indicate potential issues. For example, if the evaluated signal from a temperature sensor in the battery management system (BMS) shows an abnormal rise in temperature, it could indicate a malfunctioning cooling system or an overheating battery cell. Similarly, if the evaluated signal from a motor control unit (MCU) shows irregular motor speed fluctuations, it might suggest issues with the motor or its associated electronics.

Step 160 of method 100 comprises adapting the ECS components that are predicted to malfunction, thereby ensuring continuous and reliable operation of the ECS.

This step introduces a fault mitigation mechanism that enables the system to respond proactively to predicted malfunctions before they manifest as actual failures. Based on the output of the machine learning model in Step 150 - which may indicate a high probability of a cascading malfunction affecting one or more ECS components - the system may initiate adaptation procedures targeted at the components identified as being at risk.

Adaptation may be implemented through software-based or hardware-based corrective actions. Software-based adaptation may include recalibrating control parameters, adjusting signal thresholds, modifying logic conditions, or issuing reset commands to reinitialize the internal state of the affected ECS components. For example, if a torque sensor is predicted to drift beyond acceptable limits, the system may adjust the gain or offset parameters in the signal processing logic to compensate for the expected deviation.

In more complex scenarios, the system may reroute signal paths to bypass the predicted malfunctioning component. This may involve reconfiguring the signal operations graph to exclude the affected node and redirect its inputs and outputs to redundant or alternative components. For instance, if a primary steering angle sensor is predicted to fail, the system may switch to a secondary sensor and update the signal operations accordingly to maintain continuity in trajectory planning.

Hardware-based adaptation may involve isolating or deactivating components that are predicted to fail, thereby preventing them from propagating erroneous signals to other parts of the system. In some cases, the system may generate diagnostic messages or service alerts indicating the need for physical inspection, component replacement, or wiring repair. For example, if a power distribution unit is predicted to experience thermal overload due to sustained high current draw, the system may reduce the load on that unit by redistributing power to other zones or modules, while simultaneously flagging the issue for maintenance.

The adaptation process may be governed by a set of predefined safety policies and constraints to ensure that any corrective action does not compromise the overall functionality or safety of the ECS. These policies may define acceptable fallback behaviors, such as limiting actuator range, disabling non-critical features, or entering a degraded but safe operational mode.

Adaptation may be executed in real time or near-real time, depending on the urgency of the predicted malfunction and the nature of the corrective action. In time-critical systems, such as braking or steering control, adaptation may be triggered immediately upon detection of a high-risk condition. In less critical systems, adaptation may be deferred or scheduled based on system load, operational context, or user-defined policies.

By incorporating adaptive mechanisms that respond to predicted malfunctions, the invention enables a shift from reactive fault handling to proactive fault prevention. This capability may significantly reduce the likelihood of system-wide failures, improve fault tolerance, and extend the operational lifespan of ECS components. Moreover, it may enhance user safety and system availability, particularly in domains where uninterrupted operation is essential.

For example, following the prediction of a high-risk cascading malfunction in the Electronic Stability Control Unit (ESC), as determined in Step 150, the system proceeds to Step 160 to adapt the ESC component before the malfunction manifests. The machine learning model has assigned a risk score of 0.87 to the ESC, based on the evaluation of signal processing and the structure of the executed signal operations. This score exceeds a predefined threshold of 0.75, triggering the adaptation logic. The system identifies that the instability arises from the interaction between the torque validity signal, the brake force computation, and the lateral acceleration input - all of which feed into the ESC's stability trigger logic.

As a first line of adaptation, the system initiates a software-based correction. It modifies the signal operation responsible for computing the stability_trigger signal by introducing a temporal filter to smooth out rapid fluctuations in the torque _valid signal. Specifically, the original operation: stability_trigger = AND(brake_force > threshold, torque_valid) is replaced with: stability_trigger = AND(brake_force > threshold, LOWPASS(torque_valid, τ=0.5s)). This change introduces a low-pass filter with a 0.5-second time constant, reducing the sensitivity of the ESC to transient inconsistencies in torque validity. Additionally, the system issues a reset command to the ESC's virtual peripheral model to clear any residual state that may have accumulated due to prior instability. These adaptations are applied dynamically during simulation, without halting the system or requiring manual intervention.

To further mitigate risk, the system logs the adaptation event and flags the ESC component for post-simulation review. If the same pattern is observed repeatedly across multiple simulation runs or real-world deployments, the system may recommend a firmware update to permanently incorporate the modified logic. Through this adaptive response, the ECS virtualization framework ensures that the system remains operational and safe, even in the presence of predicted faults. This proactive approach to fault handling contrasts with traditional reactive methods, which typically respond only after a failure has occurred, and demonstrates the value of integrating predictive analytics with real-time adaptation in safety-critical control systems.

Additionally or alternatively, Step 160 of method 100 may comprise adapting the malfunctioning ECS component to function properly, thereby ensuring continuous and reliable operation of the ECS.

This step may be helpful for maintaining the overall functionality and safety of the vehicle. Once a malfunction is identified through the evaluation of signals, the method takes corrective actions to address the issue. These actions can be software-based, such as recalibrating parameters, updating firmware, or sending reset commands, or hardware-based, such as rerouting signals, replacing faulty components, or repairing damaged wiring. The goal is to identify malfunctions in ECS components quickly and efficiently, and restore the ECS component to its optimal working condition, for instance, also by simulating different scenarios in the corresponding peripheral module, preventing further issues and ensuring the vehicle continues to operate smoothly. For example, consider a scenario where the battery management system (BMS) of the ECU detects an abnormal rise in temperature due to a malfunctioning cooling system. The method might first attempt a software-based correction by recalibrating the cooling system's control parameters to enhance its performance. If the issue persists, the method could send a reset command to reinitialize the cooling system. In cases where software corrections are insufficient, the method might identify the need for hardware-based corrections, such as rerouting signals to bypass the malfunctioning cooling component or replacing the faulty cooling unit altogether. These adaptive measures ensure that the ECS component functions properly, maintaining the vehicle's safety and performance. By adapting malfunctioning peripheral models representing ECS components promptly, the method aims at minimizing downtime and preventing potential cascading failures that could affect other vehicle systems. This proactive approach enhances the reliability and longevity of the vehicle's electronic systems. Additionally, it ensures that the vehicle meets safety and performance standards, providing a better driving experience for the user. Continuous monitoring and adaptive corrections also facilitate predictive maintenance, allowing issues to be addressed before they lead to critical failures, thereby reducing maintenance costs and improving overall vehicle efficiency.

In embodiments, the evaluation of the signal processing may comprise analog and digital signal evaluation data, and the method 100 may further comprise interpreting the analog and digital signal evaluation data using a semantic model configured to: represent ECS system states and operational scenarios; and detect semantic inconsistencies in combinations of analog and/or digital signals based on contextual rules; wherein the detected inconsistencies are used to trigger anomaly alerts or initiate adapting the ECS components that are predicted to malfunction in step 150.

In the context of the present invention, a semantic model may refer to a computational representation of the operational context, logical relationships, and behavioral expectations of an electronic control system (ECS). The semantic model may encode domain-specific knowledge, such as system states, component roles, signal interdependencies, and safety constraints, in a structured format that enables reasoning over signal combinations and system behavior.

In alternative embodiments, the semantic model may be defined as a contextual rule engine, a state-aware knowledge base, or a domain-specific ontology that maps signal values and transitions to higher-level ECS states and operational scenarios. The semantic model may be implemented using rule-based logic, decision trees, knowledge graphs, or symbolic reasoning frameworks.

The term semantic inconsistency may refer to a condition in which a combination of analog and/or digital signal values violates one or more contextual rules defined in the semantic model. These inconsistencies may not be detectable through conventional range checks or logical validation alone, as they depend on the operational context and inter-signal relationships. In alternative formulations, semantic inconsistency may be defined as a contextual contradiction, a state violation, or a logical conflict under system constraints.

The integration of a semantic model into the ECS virtualization method may provide several technical advantages. First, it enables the system to detect context-sensitive anomalies that are not identifiable through static validation or signal-level thresholding. For example, a signal may be within its valid range but still represent an invalid state when considered in combination with other signals (e.g., a vehicle reporting both "engine off" and "accelerator pressed").

Second, the semantic model may enhance the explainability and traceability of anomaly detection. By linking signal inconsistencies to specific contextual rules or system states, the model may provide interpretable justifications for triggering alerts or initiating adaptation. This is particularly valuable in safety-critical domains, where traceable reasoning is essential for certification and debugging.

Third, the semantic model may serve as a bridge between low-level signal data and high-level system behavior, enabling more intelligent and targeted adaptation strategies. For instance, if a semantic inconsistency indicates that a component is operating outside its intended mode (e.g., a cooling fan running while the engine is off), the system may infer the likely cause and apply a corrective action that addresses the root of the inconsistency rather than its symptoms.

For example consider a virtualized ECS comprising a Battery Management System (BMS), a Cooling Control Unit (CCU), and a Power Distribution Module (PDM). During simulation, the BMS reports an analog signal battery_temperature = 85°C, while the CCU reports a digital signal cooling_fan_status = 0 (indicating the fan is off). According to the semantic model, a contextual rule specifies that if battery_temperature > 80°C, then cooling_fan_status must be 1 (on), as thermal management is required to prevent battery degradation.

The semantic model interprets the current signal combination and detects a semantic inconsistency: the battery is overheating, but the cooling fan is not active. This inconsistency is not a violation of individual signal ranges - both signals are within their valid domains - but the combination violates a contextual safety rule. The system triggers an anomaly alert and passes the inconsistency to the adaptation logic.

In response, the system initiates adaptation by modifying the signal operation responsible for controlling the cooling fan. It overrides the existing logic with a forced activation rule: cooling_fan_status = 1 if battery_temperature > 80°C. This ensures that the fan is activated immediately when the battery temperature exceeds the threshold, regardless of other conditions. The adaptation is logged, and the semantic model is updated to reflect the new rule, ensuring that future simulations incorporate the corrected behavior. This example illustrates how semantic interpretation enables the system to detect and resolve context-specific faults that would otherwise go unnoticed in traditional ECS validation frameworks.

The term evaluation of the signal processing refers to the computational results produced by executing signal operations between ECS components during simulation. These results may include analog and digital signal values, intermediate transformation outputs, and derived metrics that reflect the dynamic behavior of the ECS under simulated conditions. In alternative formulations, this concept may be described as signal evaluation data, processed signal outputs, or runtime signal states. For example, evaluating the signal processing may yield values such as cooling_demand = 68.4 or headlight_trigger = 1, derived from mathematical and logical operations applied to sensor inputs and control flags.

The phrase analog and digital signal evaluation data refers to the categorized results of signal processing, where analog data may include continuous values such as voltage, temperature, or current, and digital data may include discrete states such as binary flags, control bits, or logical outputs. These data are generated during simulation and serve as input to further reasoning or prediction mechanisms. Alternative definitions may include evaluated signal outputs, simulation-derived signal values, or component-level signal states. For instance, analog signal evaluation data may include battery_temperature = 85.2°C, while digital signal evaluation data may include fan_enable = 0.

The term semantic model refers to a structured representation of ECS system knowledge, including component roles, operational states, and contextual rules, used to interpret signal data and detect inconsistencies. The semantic model may be implemented as a rule-based engine, ontology, or knowledge graph. Alternative formulations may include contextual reasoning framework, rule-based validation system, or knowledge-based ECS model. For example, a semantic model may define that if battery_temperature > 80°C, then fan_enable must be 1, and flag a semantic inconsistency if this rule is violated.

The phrase ECS system states and operational scenarios refers to defined modes, conditions, and behaviors of ECS components under various simulated or real-world conditions. These may include normal operation, fault states, transitional modes, and safety-critical configurations. Alternative definitions may include component-level operational contexts, system-wide behavioral modes, or simulation scenarios. For example, an operational scenario may involve the vehicle being in motion with headlights on and cooling active, while a system state may represent the ECS being in thermal protection mode.

The term semantic inconsistencies refers to combinations of signal values that violate contextual rules defined in the semantic model, even if individual signals are within valid ranges. These inconsistencies indicate logically invalid or unsafe system states. Alternative formulations may include contextual contradictions, rule violations, or system-level logical conflicts. For example, if cooling_fan_status = 0 while battery_temperature = 85°C, the semantic model may detect an inconsistency, as cooling should be active under such thermal conditions.

The phrase anomaly alerts refers to notifications or flags generated by the system when semantic inconsistencies or predicted faults are detected. These alerts may be used to initiate corrective actions or log diagnostic events. Alternative definitions may include fault prediction notifications, diagnostic flags, or system warnings. For example, an anomaly alert may be triggered when the semantic model detects that the radar fault flag is active while the emergency braking system remains disabled. Finally, the phrase adapting the ECS components that are predicted to malfunction refers to the application of software-based or hardware-based corrective actions to ECS components identified by the machine learning model or semantic model as being at risk of failure. Adaptation may occur before actual malfunction manifests. Alternative formulations may include proactive fault mitigation, predictive reconfiguration, or preemptive correction of high-risk components. For example, if the machine learning model predicts a high probability of failure in the fan relay, the system may reroute control signals to a redundant relay and flag the component for inspection.

In embodiments, the semantic model may comprise a rule-based ontology or a knowledge graph representing ECS system states and relationships between analog and digital signal conditions.

In embodiments, the semantic model may comprise a rule-based ontology or a knowledge graph representing ECS system states and relationships between analog and digital signal conditions. A rule-based ontology may be defined as a structured set of logical rules and hierarchical relationships that encode domain-specific knowledge about ECS components, their operational modes, and the expected behavior of signal combinations. A knowledge graph, in this context, may refer to a graph-based data structure in which nodes represent ECS components, system states, or signal entities, and edges represent semantic relationships, such as causality, dependency, or conditional activation.

In alternative formulations, the semantic model may be described as a contextual reasoning engine, a signal-state mapping framework, or a state-aware validation layer. These alternative definitions may be used during prosecution to clarify the scope of the semantic model or to distinguish it from purely syntactic or statistical models. The semantic model may be implemented using rule engines, graph databases, or hybrid symbolic-neural architectures, depending on the complexity and expressiveness required.

In embodiments, interpreting the analog and digital signal evaluation data using the semantic model may comprise: mapping said signal evaluation data to semantic entities representing ECS components and ECS system states; applying contextual rules to evaluate the logical coherence of the mapped entities; and generating alerts or annotations for signal combinations that violate semantic consistency.

Interpreting the analog and digital signal data using the semantic model may comprise at least one of the following operations: receiving the signal data from the interfaces of the peripheral models; mapping the signal data to semantic entities representing ECS components and ECS system states; applying contextual rules to evaluate the logical coherence of the mapped entities; and generating alerts or annotations for signal combinations that violate semantic consistency. In alternative language, this process may be described as semantic parsing of signal inputs, contextual rule evaluation, or state-based anomaly detection.

The use of a rule-based ontology or knowledge graph within the semantic model may provide several technical advantages. First, it enables the system to perform context-aware validation of signal combinations, going beyond conventional range checks or logical operations. By encoding system-level expectations and dependencies, the semantic model may detect violations that arise only under specific operational scenarios, such as contradictory states or unsafe transitions.

Second, the semantic model may improve the interpretability and traceability of anomaly detection. When an inconsistency is detected, the system may reference the specific rule or graph path that was violated, allowing developers or safety engineers to understand the root cause and assess the impact. This is particularly valuable in regulated domains, where explainability is essential for certification and compliance.

Third, the semantic model may support adaptive behavior by linking detected inconsistencies to specific ECS components and system states. This linkage may enable targeted adaptation strategies, such as reconfiguring signal logic, isolating faulty components, or modifying control parameters. The semantic model may also facilitate incremental learning, allowing new rules or relationships to be added as the ECS evolves or as new failure modes are discovered.

For example, consider a virtualized ECS comprising a Climate Control Unit (CCU), a Cabin Temperature Sensor (CTS), and a Fan Actuator Module (FAM). During simulation, the CTS reports an analog signal cabin_temp = 28°C, while the CCU reports a digital signal ac_status = 0 (indicating the air conditioning is off), and the FAM reports fan_speed = 0 (fan is off). According to the semantic model, a contextual rule specifies that if cabin_temp > 26°C, then either ac_status = 1 or fan_speed > 0 must be true to maintain thermal comfort.

The semantic model receives the signal data from the peripheral model interfaces and maps them to semantic entities: CabinTemperature, AirConditioningState, and FanSpeed. It then applies the contextual rule and determines that the current signal combination violates the expected behavior for the given system state. The semantic inconsistency is flagged, and an alert is generated indicating that the climate control system is not responding appropriately to elevated cabin temperature.

In response, the system may annotate the signal trace with the violated rule and initiate adaptation. For example, it may override the fan_speed signal to a default value of 2 (medium speed) or activate the air conditioning by setting ac_status = 1. This adaptation ensures that the ECS maintains comfort and safety standards, even in the presence of misconfigured or unresponsive components. The semantic model thus enables intelligent, context-sensitive fault detection and correction that would not be possible through signal-level validation alone.

The phrase mapping said signal evaluation data to semantic entities representing ECS components and ECS system states refers to the process of associating evaluated analog and digital signal data-generated during simulation-with abstract representations of ECS components and their operational modes. Semantic entities may include component-level abstractions such as "Battery Management Unit," "Cooling Fan Relay," or "Radar Sensor," as well as system states like "Thermal Protection Mode" or "Collision Avoidance Active." This mapping enables the semantic model to reason about signal behavior in the context of system-level logic. For example, a signal value battery_temperature = 85°C may be mapped to a semantic entity representing the battery subsystem in an "Overheat Risk" state. The technical advantage of this mapping is that it allows the system to interpret signal data not just as isolated values, but as meaningful indicators of system behavior, enabling context-aware validation and fault detection.

The phrase applying contextual rules to evaluate the logical coherence of the mapped entities refers to the use of predefined or dynamically generated rules within the semantic model to assess whether the current combination of mapped signal states and component conditions is logically valid. These rules may encode safety constraints, operational dependencies, or behavioral expectations. For example, a rule may specify that if battery_temperature > 80°C, then cooling_fan_status must be 1. If the fan is off while the battery is overheating, the rule is violated, indicating a semantic inconsistency. The technical effect of applying contextual rules is the ability to detect faults that are not evident from signal values alone-such as contradictory states or unsafe transitions-thereby improving diagnostic precision and system robustness.

The phrase generating alerts or annotations for signal combinations that violate semantic consistency refers to the system's response when a contextual rule is violated. An alert may be a diagnostic message, a logged event, or a trigger for adaptation logic. An annotation may involve marking the affected signal path or component in a visual representation or simulation trace. For example, if the semantic model detects that radar_fault_flag = 1 while emergency_brake_status = 0, it may generate an alert indicating a suppressed safety function and annotate the radar and brake components for review. The technical advantage of this mechanism is that it enables early, interpretable fault detection and supports proactive system correction, especially in safety-critical ECS domains such as automotive or aerospace.

Together, these steps provide a structured, semantic layer of reasoning that complements signal-level validation and machine learning-based prediction. They enable the system to understand not just what the signals are, but what they mean in the context of ECS operation.

In embodiments, the machine learning model may be implemented as a multi-layer perceptron (MLP) or a graphical neural network (GNN) trained on historical analog and digital signal data representing dependencies between ECS components. A multi-layer perceptron may be defined as a feedforward neural network comprising multiple layers of interconnected neurons, each applying nonlinear activation functions to transform input features into predictive outputs. A graphical neural network may be defined as a neural architecture that operates on graph-structured data, where nodes represent ECS components or signals and edges represent dependencies or signal flow relationships.

In alternative formulations, the machine learning model may be described as a deep neural classifier, a signal dependency predictor, or a topology-aware anomaly detector. These alternative definitions may be used during prosecution to broaden or clarify the scope of the model architecture.

The technical effect of using an MLP or GNN lies in the model's ability to capture both local signal patterns and global structural dependencies. An MLP may be efficient for learning temporal or statistical correlations in signal values, while a GNN may be better suited for modeling the propagation of faults across interconnected ECS components.

For example, consider a graph where nodes represent a brake pedal sensor, a wheel speed sensor, and an ABS controller. Historical data show that when the brake pedal is pressed and wheel speed drops rapidly, the ABS controller should activate. A GNN trained on such data may learn this dependency and predict a malfunction if the ABS controller fails to respond under similar conditions, even if individual signals appear valid.

In embodiments, the machine learning model may be configured to operate in a hybrid mode, comprising offline training on historical analog and digital signal data and real-time inference during simulation to emulate live prediction of Step 150. Offline training may refer to the process of fitting the model parameters using pre-collected datasets, while real-time inference may refer to the application of the trained model to incoming signal data during simulation, without retraining.

In alternative language, this hybrid mode may be described as batch-trained, runtime-deployed, or pretrained, simulation-integrated. These formulations may be used to distinguish the invention from systems that require continuous online learning or manual rule tuning.

The technical effect of hybrid execution is twofold: it allows the model to benefit from robust training on large datasets, while maintaining low-latency prediction during simulation. This separation of training and inference phases ensures computational efficiency and scalability, especially in embedded or resource-constrained environments.

For example, a model trained offline on 10,000 ECS simulation traces may learn to predict overheating in a power distribution module based on voltage and current patterns. During simulation, the model may receive live signal evaluations and immediately output a risk score of 0.92 for the module, triggering adaptation before thermal thresholds are breached.

In embodiments, the method may further comprise dynamically validating signal consistency during simulation by at least one of: monitoring transitions of the analog and digital signal data generated in Step 140; verifying that the analog signals remain within predefined valid ranges; verifying that the digital signals remain within binary states; and checking logical consistency of signal transitions between ECS components.

In alternative formulations, this process may be described as runtime signal integrity checking, live signal domain validation, or inter-component signal coherence monitoring. These definitions may be used to clarify the scope of validation beyond static or design-time checks.

The technical effect of dynamic validation is the ability to detect real-time anomalies that may arise due to transient conditions, signal noise, or unexpected interactions between components. Unlike static validation, which only checks configuration correctness, dynamic validation ensures that signal behavior remains consistent and safe throughout the simulation lifecycle.

For example, during a braking simulation, the analog signal brake_pressure may spike to 120 bar, exceeding the predefined safe range of 0-100 bar. Simultaneously, the digital signal brake_engaged may toggle rapidly between 0 and 1, indicating instability. The system detects these anomalies and flags a potential malfunction in the hydraulic control unit, prompting further analysis or adaptation.

In embodiments, the signal operations obtained in Step 3 may include at least one of: AND, OR, XOR, and NOT for digital signals, and at least one of: multiplication (MUL) and addition (ADD) for analog signals. The term signal operations may refer to computational functions applied to signal values exchanged between ECS components, used to simulate logical decision-making and mathematical transformations within the virtualized ECS. Logical operations may be defined as binary or unary functions that operate on digital signals represented as discrete states (e.g., 0 or 1), while mathematical operations may be defined as arithmetic functions applied to continuous analog signals.

In alternative formulations, signal operations may be described as signal transformation functions, inter-component signal logic, or simulation-level signal processing rules. These definitions may be used during prosecution to clarify the scope of operations and distinguish them from hardware-level signal manipulation.

The technical effect of defining signal operations in this manner is to enable structured and consistent simulation of ECS behavior. Logical operations may simulate control logic, such as safety interlocks or activation conditions, while mathematical operations may model physical relationships, such as force, temperature, or voltage computations.

For example, in a braking system, the digital signal brake_engaged may be computed as AND(pedal_pressed, system_ready), while the analog signal brake_force may be computed as MUL(pedal_pressure, hydraulic_gain). These operations allow the system to simulate realistic braking behavior and detect inconsistencies or faults in signal propagation.

In embodiments, the signal operations may be implemented using prefix notation for wiring descriptions, and signal processing evaluation may be performed via pre-order traversal of a tree structure. Prefix notation, also known as Polish notation, may refer to a format in which each operation precedes its operands, allowing for unambiguous parsing without parentheses. A tree structure may represent the hierarchical composition of signal operations, where each node corresponds to an operation and each leaf corresponds to a signal input.

In alternative formulations, prefix notation may be described as operator-first signal logic encoding, and tree-based evaluation may be referred to as recursive signal computation or hierarchical signal processing. These definitions may be used to distinguish the invention from flat or sequential signal evaluation methods.

The technical effect of using prefix notation and tree traversal is to enable efficient and scalable parsing and evaluation of complex signal logic. This structure supports modularity, reuse, and dynamic reconfiguration of signal operations, which is particularly valuable in large ECS systems with many interconnected components.

For example, the operation AND(NOT(sensor_fault), speed_ok) may be represented in prefix form and parsed into a tree with AND as the root, NOT and speed_ok as children, and sensor_fault as the leaf under NOT. Pre-order traversal evaluates NOT(sensor_fault) first, then AND(...), producing a final decision signal for enabling torque assistance.

In embodiments, implementing the signal operations using prefix notation may comprise: describing wiring of signals between the ECS components using prefix notation; parsing the prefix notation to construct a tree structure representing the signal operations; and performing signal processing evaluation via pre-order traversal of the tree structure. The wiring description may define how signals are routed and combined across ECS components, using prefix notation to encode the logic. Parsing may involve converting the notation into a computational tree, and evaluation may involve recursively computing signal values from the leaves to the root.

In alternative language, this process may be described as prefix-based signal graph construction, syntax-driven signal logic parsing, or tree-based ECS signal evaluation. These formulations may be used to clarify the implementation method and distinguish it from conventional ECS simulation approaches.

The technical effect of this implementation is to provide a formal and extensible mechanism for defining and executing signal logic in a virtualized ECS. It allows for automated validation, dynamic reconfiguration, and integration with higher-level reasoning systems such as semantic models or machine learning predictors.

For example, consider a signal wiring description: OR(AND(brake_pressed, speed_ok), override_signal). This prefix string may be parsed into a tree with OR at the root, AND and override_signal as children, and brake_pressed and speed_ok as leaves under AND. During simulation, the system may evaluate this tree to determine whether braking assistance should be activated, based on both normal conditions and override inputs.

In embodiments, the method may further comprise performing validation checks during startup of the method or of a system executing the method, the validation checks including at least one of: syntax checks, semantic checks, compatibility checks, and consistency checks, thereby ensuring the peripheral models accurately represent the respective ECS components. The term startup validation checks may refer to a set of automated procedures executed prior to simulation or deployment, intended to verify the correctness and integrity of the ECS virtualization configuration.

In alternative formulations, these checks may be described as initialization integrity checks, pre-simulation model verification, or configuration-level validation routines. These definitions may be used to distinguish the invention from runtime validation or post-processing diagnostics.

The technical effect of performing startup validation is to prevent simulation errors, misconfigurations, and unsafe signal interactions before they propagate through the system. By ensuring that peripheral models are correctly defined and signal logic is syntactically and semantically valid, the system may reduce debugging time, improve simulation reliability, and enhance safety assurance.

For example, during startup, the system may detect that a peripheral model for a throttle actuator has been assigned both analog and digital signal types for the same interface, violating compatibility rules. The system flags the error and halts simulation, preventing invalid behavior and ensuring model fidelity.

In embodiments, the validation checks during startup may further comprise at least one of: performing syntax checks to ensure correct use of parentheses in the signal operations; performing semantic checks to ensure the signal operations are correct; performing compatibility checks to ensure no mixing between the analog signals group and the digital signals group; and performing consistency checks to ensure connections between the peripheral models are valid, comprising not connecting input to input or output to output.

In alternative formulations, these checks may be described as signal logic syntax enforcement, semantic rule conformance, signal type segregation, and interface connection validation. These definitions may be used to clarify the scope of validation and distinguish it from runtime signal monitoring.

The technical effect of these detailed checks is to ensure that signal operations are not only syntactically correct but also logically coherent and physically plausible. This prevents subtle errors such as miswired interfaces, ambiguous signal types, or invalid logical expressions that could compromise simulation accuracy or safety.

For example, the system may parse the signal operation AND(NOT(brake_pressed speed_ok)) and detect a missing comma or parenthesis, flagging a syntax error. It may also detect that a signal operation mixes analog and digital operands, violating compatibility rules, and suggest correction before simulation begins.

In embodiments, the method may further comprise processing signals between the peripheral models in a sequence to ensure updated data, including sorting nodes and edges in a graph to ensure each node is processed only after all its dependencies have been processed. This process may be referred to as dependency-aware signal evaluation, where the signal operations are organized into a directed acyclic graph (DAG) representing computation dependencies.

In alternative formulations, this may be described as topological signal scheduling, graph-based signal propagation, or dependency-resolved signal execution. These definitions may be used to distinguish the invention from flat or unordered signal processing methods.

The technical effect of this approach is to ensure that signal values are computed in a logically consistent order, avoiding race conditions, circular dependencies, or stale data propagation. This is particularly important in systems with complex inter-component logic, where the correctness of one signal depends on the timely evaluation of others.

For example, in a powertrain simulation, the signal engine_torque may depend on throttle_position, which in turn depends on pedal_input. The system constructs a graph and ensures that pedal_input is evaluated first, followed by throttle_position, and finally engine_torque, preserving logical causality.

In embodiments, adapting the ECS components that are predicted to malfunction may comprise software-based corrections and/or hardware-based corrections. Software-based corrections may include recalibration of control parameters, firmware updates, or issuing reset commands. Hardware-based corrections may include signal rerouting, component isolation, or diagnostic feedback for physical replacement or wiring repair.

In alternative formulations, these adaptations may be described as virtual fault mitigation, component-level recovery actions, or predictive maintenance triggers. These definitions may be used to broaden the scope of adaptation and distinguish it from reactive fault handling.

The technical effect of enabling both software and hardware adaptation is to provide a comprehensive fault response mechanism that can operate across simulation and deployment contexts. Software corrections may be applied immediately during simulation, while hardware corrections may inform maintenance actions or trigger fallback configurations in real systems.

For example, if the machine learning model predicts a high risk of overheating in a battery management unit, the system may reduce current draw via software control and simultaneously flag the unit for inspection. If wiring degradation is suspected, the system may reroute signals to bypass the affected path and log the issue for repair.

In embodiments, the method may comprise software-based corrections applied to ECS components that are predicted to malfunction. These corrections may include at least one of: recalibration by adjusting software parameters associated with the ECS components to correct minor deviations of the components' output; firmware updates to fix software bugs or improve performance; and reset commands to reinitialize the ECS components. The term software-based corrections may refer to any modification of the ECS component's behavior through changes in its software configuration, logic, or runtime state, without requiring physical intervention.

In alternative formulations, software-based corrections may be described as virtual fault mitigation routines, parameter-level recovery actions, or runtime control logic adjustments. These definitions may be used to distinguish the invention from hardware-based fault handling or manual servicing.

The technical effect of software-based corrections is to enable rapid, automated recovery from predicted faults, minimizing system downtime and avoiding escalation into physical failures. These corrections may be applied dynamically during simulation or runtime, allowing the ECS to maintain operational continuity even under degraded conditions.

For example, if a temperature sensor in a battery management system is predicted to drift due to thermal stress, the system may recalibrate its output by adjusting the offset parameter in the signal processing logic. Alternatively, if a control unit exhibits unstable behavior due to a known firmware bug, the system may apply a patch and reinitialize the unit using a reset command, restoring stable operation without halting the simulation.

In embodiments, the method may comprise hardware-based corrections applied to ECS components that are predicted to malfunction. These corrections may include at least one of: signal rerouting comprising sending signals to bypass the ECS components; component replacement comprising identifying a need for physical replacement of faulty sensors or actuators and sending feedback to a user; and wiring repairs comprising detecting and suggesting repairs for damaged or corroded wiring inside and/or outside the ECS components. The term hardware-based corrections may refer to any physical-level intervention or reconfiguration intended to restore or maintain ECS functionality.

In alternative formulations, hardware-based corrections may be described as physical fault isolation, component-level maintenance triggers, or signal path reconfiguration strategies. These definitions may be used to broaden the scope of adaptation and distinguish it from software-only solutions.

The technical effect of hardware-based corrections is to provide actionable insights and automated responses to faults that cannot be resolved through software alone. By identifying the physical source of a malfunction and suggesting or initiating corrective measures, the system may reduce the risk of cascading failures and improve long-term system reliability.

For example, if a steering angle sensor is predicted to fail due to mechanical wear, the system may reroute the signal to a redundant sensor and notify the user that the primary sensor requires replacement. If signal degradation is traced to corroded wiring in the front axle harness, the system may log the fault and recommend targeted repair, preventing further signal loss or control instability.

In embodiments, the method may comprise a logging interface configured to support multiple interchangeable backends, including: a basic logging backend for raw signal capture; a historical data backend for time-series analysis; and a machine learning backend for predictive analytics. The term logging interface may refer to a modular software component responsible for collecting, formatting, and routing signal data generated during ECS simulation or operation.

In alternative formulations, the logging interface may be described as a signal trace management layer, a data acquisition module, or a runtime telemetry framework. These definitions may be used to clarify the scope of logging and distinguish it from fixed or monolithic data capture systems.

The technical effect of supporting interchangeable backends is to enable flexible integration of the ECS virtualization system with various analysis tools and workflows. Developers may choose the appropriate backend depending on the simulation goals - whether for debugging, performance profiling, or anomaly prediction - without modifying the core ECS logic.

For example, during early-stage testing, the basic logging backend may record raw signal transitions for manual inspection. In later stages, the historical backend may store time-series data for trend analysis, while the machine learning backend may feed signal evaluations into a trained model to predict faults. This modularity enhances the system's adaptability and supports continuous improvement across development cycles.

In embodiments, the logging interface may be further configured to capture and timestamp intermediate signal transformation results between ECS components. The term *intermediate signal transformation results* may refer to the outputs of signal operations that occur between initial signal input and final signal evaluation, including partial computations, logical sub-expressions, and intermediate values within multi-stage signal processing chains. Timestamping may refer to the association of each captured result with a simulation time index or real-time marker, enabling temporal analysis and traceability.

In alternative formulations, this functionality may be described as signal trace logging, stage-wise signal capture, or temporal signal transformation monitoring. These definitions may be used to distinguish the invention from systems that only log final signal outputs or static configurations.

The technical effect of capturing intermediate signal transformations is to enable fine-grained debugging, root-cause analysis, and model transparency. By observing how signals evolve through each transformation stage, developers may identify logic errors, timing mismatches, or unexpected interactions that would be difficult to detect from final outputs alone.

For example, in a steering control system, the signal assist_enable = AND(speed_ok, NOT(sensor_fault)) may be decomposed into intermediate results: NOT(sensor_fault) = 1, speed_ok = 1, and AND(...) = 1. If the final output is incorrect, the logged intermediate values may reveal that sensor_fault was misinterpreted due to a delayed update, allowing targeted correction.

In embodiments, the system may be configured to generate a visual representation of the signal flow and validation results, including: highlighting inconsistent or anomalous signal paths; and annotating signal nodes with validation status and predicted failure probabilities. The term *visual representation* may refer to a graphical interface or diagram that depicts the structure and behavior of signal operations, component interactions, and validation outcomes within the ECS simulation.

In alternative formulations, this may be described as a signal flow visualization engine, diagnostic graph renderer, or interactive ECS validation dashboard. These definitions may be used to clarify the scope of visualization and distinguish it from textual or tabular reporting.

The technical effect of visualizing signal flow and validation results is to improve developer comprehension, fault localization, and simulation transparency. By presenting signal logic and validation outcomes in an intuitive format, the system may accelerate debugging, facilitate certification, and support collaborative development.

For example, in a zonal control unit simulation, the system may display a graph where each node represents a signal or component, and edges represent signal operations. Nodes with failed validation checks may be highlighted in red, and predicted failure probabilities may be shown as heatmap overlays. This allows engineers to quickly identify problematic areas and assess system health.

In embodiments, the system may be integrated into a continuous integration (CI) or hardware-in-the-loop (HiL) testing pipeline to automatically validate ECS configurations during development. CI integration may refer to the automated execution of ECS simulations and validation routines as part of a software build and test workflow. HiL integration may refer to the execution of ECS simulations in conjunction with physical hardware components to validate real-world behavior.

In alternative formulations, this may be described as automated ECS validation orchestration, simulation-driven test automation, or real-time ECS verification framework. These definitions may be used to distinguish the invention from manual or ad hoc testing approaches.

The technical effect of CI and HiL integration is to enable early fault detection, regression prevention, and deployment readiness. By validating ECS configurations continuously and in realistic environments, the system may reduce development time, improve reliability, and ensure compliance with safety standards.

For example, during nightly CI runs, the ECS virtualization system may simulate 100 vehicle scenarios and automatically flag any configuration that causes signal inconsistencies or predicted failures. In a HiL setup, the system may validate that a real brake pedal sensor produces expected signal behavior under simulated load conditions, ensuring hardware-software compatibility.

Consider a virtualized ECS for a front-zone control unit (ZCU) in an electric vehicle. The ZCU manages multiple subsystems, including front lighting, radar and lidar sensors, cooling fans, and power distribution. The method begins by abstracting signal properties: analog signals such as ambient_light_level = 320 lux, radar_range = 18.5 m, and coolant_temperature = 92°C are grouped separately from digital signals like headlight_status = 1, radar_fault_flag = 0, and fan_enable = 0. This categorization enables tailored processing paths, reducing complexity and improving simulation efficiency.

Peripheral models are obtained for each subsystem. For example, the lighting model includes interfaces for ambient light sensors and headlight control, while the radar model includes interfaces for range detection and fault flags. Signal operations are defined using logical and mathematical expressions such as headlight_trigger = AND(ambient_light_level < 400, vehicle_speed > 0) and cooling_demand = MUL(coolant_temperature, thermal_coefficient). These operations are encoded in prefix notation and parsed into tree structures for efficient evaluation via pre-order traversal.

During simulation, the system executes these signal operations and evaluates the signal processing between components. Intermediate results such as cooling_demand = 92 × 0.75 = 69.0 and headlight_trigger = 1 are captured and timestamped by the logging interface. The logging interface supports multiple interchangeable backends: raw signal capture for debugging, historical time-series analysis for trend detection, and machine learning integration for predictive analytics.

The machine learning model, implemented as a graphical neural network (GNN), receives both the evaluated signal data and the structure of the executed signal operations. Trained offline on thousands of zonal ECS traces, the model identifies that the current signal pattern - high coolant temperature, inactive fan, and active headlight - matches a known precursor to thermal overload in the front power distribution module (PDM). It outputs a risk score of 0.89 for the PDM, triggering Step 150.

In Step 160, the system adapts the PDM proactively. A software-based correction is applied: the fan control logic is overridden to force activation (fan_enable = 1), and the thermal coefficient is recalibrated to reduce cooling demand. Simultaneously, a hardware-based correction is suggested: the system flags the fan relay for inspection and recommends wiring diagnostics for the coolant sensor. These adaptations ensure continued operation and prevent thermal failure.

Before simulation begins, the system performs startup validation checks. Syntax validation confirms correct use of parentheses in signal operations, semantic checks verify logical coherence, compatibility checks ensure analog and digital signals are not mixed improperly, and consistency checks confirm valid wiring between peripheral models. For example, the system detects and corrects an invalid connection between two output ports in the radar model.

Signal processing is performed in a dependency-aware sequence. The system constructs a graph of signal operations and sorts nodes such that ambient_light_level is evaluated before headlight_trigger, and coolant_temperature before cooling_demand. This ensures logical causality and prevents stale data propagation.

Throughout simulation, the system generates a visual representation of signal flow. Nodes representing signals and components are annotated with validation status and predicted failure probabilities. In this case, the PDM node is highlighted in red with a failure probability of 89%, and the cooling_demand path is marked as anomalous. This visualization aids engineers in diagnosing issues and verifying system behavior.

Finally, the system is integrated into a continuous integration (CI) pipeline. Each time the ZCU configuration is updated, the simulation runs automatically, validating signal logic, checking for semantic inconsistencies, and updating the machine learning model with new data. In a hardware-in-the-loop (HiL) setup, the virtual ZCU interacts with real sensors and actuators, confirming that the simulated adaptations correspond to physical responses.

This example demonstrates how the invention enables modular ZCU virtualization, context-aware validation, predictive fault detection, and proactive adaptation, all within a scalable and traceable simulation framework. It highlights the technical effects of each claim and the synergistic benefits of integrating semantic reasoning, machine learning, and structured signal logic into zonal ECS development and validation.

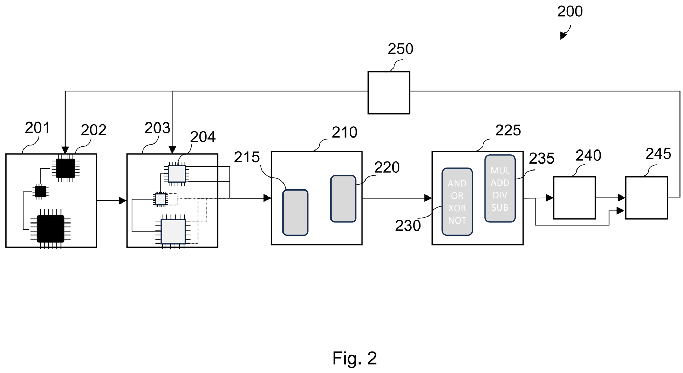

Fig. 2 shows a schematic illustrating a system 200 used for virtualizing an electronic control system (ECS) according to Method 100. The system 200 may comprise a modular architecture that reflects the steps of Method 100 and supports scalable, interpretable, and predictive ECS simulation and validation.

The system 200 may include a signal categorization module (210) configured to categorize signals in ECS components (202) into distinct groups, including an analog signals group (215) and a digital signals group (220). These groups may be strictly separated to facilitate distinct processing paths for different signal types.

Analog signals may include voltage, current, temperature, or pressure values, while digital signals may include binary states, flags, or control bits. This separation simplifies signal handling and enables tailored processing logic.

A standardized interface module (203) may encapsulate peripheral models (204) associated with respective ECS components (202). Each peripheral model may comprise interfaces that correspond to the actual hardware interfaces of the ECS component. Each interface may be associated with a signal-either analog or digital, input or output-matching the real-world signal behavior. Signals may be acquired from the ECS component interfaces via measurement, reading, replication, or mapping, including in real-time. This encapsulation enables scalable integration of diverse peripherals and supports future component substitution with minimal reconfiguration.

A signal operations module (225) may obtain, for each peripheral model (205), signal operations that virtualize the signal processing logic of the respective ECS component. These operations may include logical operations (230) such as AND, OR, XOR, and NOT for digital signals, and mathematical operations (235) such as multiplication (MUL), addition (ADD), division (DIV), and subtraction (SUB) for analog signals. These operations may be expressed in prefix notation, allowing for efficient parsing and recursive evaluation via pre-order traversal of a tree structure. This structure supports the construction of directed acyclic graphs (DAGs), where the root represents the result and the leaves represent input pins.

A signal evaluation module (240) may execute the signal operations to evaluate signal processing between ECS components. Intermediate transformation results may be captured and timestamped by a logging interface, which may support multiple interchangeable backends: a basic backend for raw signal capture, a historical backend for time-series analysis, and a machine learning backend for predictive analytics.

A prediction module (245) may comprise a machine learning model configured to use the evaluation of signal processing and/or the executed signal operations to predict cascading malfunctions across multiple ECS components. The model may be implemented as a multi-layer perceptron (MLP) or a graphical neural network (GNN), trained offline on historical analog and digital signal data representing dependencies between ECS components. During simulation, the model may operate in a hybrid mode, performing real-time inference to emulate live prediction behavior. It may output risk scores for components and trigger alerts or adaptation logic when thresholds are exceeded.

A component adaptation module (250) may adapt ECS components that are predicted to malfunction. Adaptation may include software-based corrections, such as recalibration of parameters, firmware updates, or reset commands, and hardware-based corrections, such as signal rerouting, component replacement, or wiring repair suggestions. These actions may be applied proactively to maintain continuous and reliable ECS operation.

The system may further perform validation checks during startup, including syntax checks (e.g., verifying parentheses in signal operations), semantic checks (e.g., ensuring logical correctness), compatibility checks (e.g., preventing mixing of analog and digital signals), and consistency checks (e.g., ensuring valid input/output wiring). These checks ensure that peripheral models accurately represent the ECS components and prevent simulation errors.

Signal processing may be performed in a dependency-aware sequence, where nodes and edges in a signal graph are sorted to ensure each node is processed only after its dependencies. This guarantees logical causality and prevents stale data propagation.

The system may also generate a visual representation of signal flow and validation results, highlighting inconsistent or anomalous signal paths and annotating signal nodes with validation status and predicted failure probabilities. This visualization supports debugging, certification, and system understanding.

Finally, the system may be integrated into a continuous integration (CI) or hardware-in-the-loop (HiL) testing pipeline to automatically validate ECS configurations during development. This integration enables early fault detection, regression prevention, and deployment readiness.

All definitions, technical effects, and examples provided for the steps, components, and features of Method 100 apply equally to System 200. Together, they provide a comprehensive framework for ECS virtualization, validation, and predictive fault management.

Further examples of the disclosed method are provided herein. For instance, the wiring of the components may be created based on a logical schematic. In this schematic, certain signal transformations may occur, such as a logical OR of multiple signals. In the virtual system or the peripheral models discussed above, each signal can be individually examined and debugged. The concrete steps to the method disclosed herein may include: Abstraction of a technical schematic to a logical schematic; Encapsulation of peripheral models behind a common interface; Abstraction of signals; Creation of logical and technical signal operations: and Wiring and recursive evaluation of networks.

Abstraction of a Technical Schematic to a Logical Schematic: It is not important which resistor and which transistor are used. What matters is what happens to the signal. Two groups of signals may be identified: A) Technical signals (voltages and currents) that can be transformed through technical operations (e.g., voltage divider), and B) Logical signals (digital IO and PWM) that can be transformed through logical operations (e.g., AND, OR, XOR, NOT). The two groups may be strictly separated, i.e. these signals cannot be connected.

Encapsulation of Peripheral Models Behind a Common Interface: Peripherals are smaller integrated circuits in a package that can be connected externally via pins. The vast number of different peripherals requires a scalable concept, allowing future peripherals to be added without needing to adjust the rest of the virtualization environment. Additionally, a project might switch to another derivative of a peripheral, which should cause minimal effort in virtualization. Therefore, the commonalities of all peripherals are used to define a common interface: Each peripheral (also called peripheral model throughout this disclosure) has a number of pins, where each pin: Transmits a signal of type DIO: Digital Input/Output, PWM: Pulse Width Modulation, SPI: Serial Peripheral Interface, Voltage, Current. Each pin is identified by a unique name, and each pin is either Input (read-write) or Output (read-only).

In the software, this peripheral may be represented in C++ through a pure virtual interface, but can also be implemented in other languages. Object-oriented languages may be more suitable for this purpose than procedural languages.

Abstraction of Signals (for the peripheral models): Some properties of signals that occur in the real world may be abstracted to reduce complexity and make the system easier to analyze: The transient behavior of signals is not considered (e.g., a switch from OFF to ON takes a few microseconds to stabilize in hardware). Physical influencing factors such as temperature or pressure are assumed to be ideal. The accuracies of Voltage and Current are represented as floating-point values. The values of DIO are 0 or 1 instead of 0V and 12V. A PWM signal changes its state faster than the simulation clock and therefore cannot be simulated 1:1. Instead, the percentage time share of a PWM signal is used. Said percentage time share may be called DutyCycle in hardware. However, said hardware DutyCycle may be reduced, from the real range from 0 to 8000, to the range of 0 to 100 to make debugging easier. If a PWM signal has 33% intensity, then 33% is easier to understand in the log than 2667. The accuracy remains sufficient for virtualization.

The timing behavior of virtualization or the peripheral models is different from that in the real world. This is mainly due to the resources (RAM, ROM) available to the virtual environment, but also because the 10ms clock from ECS such as ClassicAutosar cannot be virtualized, as such fine-grained timers are not available on a typical operating system. It follows that all real-time-related tests or expectations may not be guaranteed to be met at all times, as this may in some case defy the purpose of the approach disclosed herein, which is abstracting and simplifying complex systems and operations for quick and efficiency functionality validation purposes.

Creation of Logical and Technical Signal Operations: The goal of creating these operations is to virtualize all signal processing processes on the PCB. The following operations may be implemented: For Voltage and Current: To enable voltage dividers and amplifiers, at least one of the operations MUL, ADD, DIV and SUB may be used. Reading constant values that serve as factors or summands.

For DIO and PWM: The NOT operation negates a signal, meaning the signal type remains the same. The AND, OR, and XOR operations can be applied to multiple DIO signals and at most one additional PWM signal.

In addition, exploiting the fact that each operation yields exactly one result: This allows for the construction of DAG (Directed Acyclic Graph) tree structures. The root of the tree structure represents the result of the operation, while the leaves of the tree represent the input pins from which values are read.

Wiring and Recursive Evaluation of Networks: A prefix notation may be used to describe the wiring. For instance: The notation "A && B" as commonly used in C language, may be an infix notation because the operation is between the operands. Processing such a term is unnecessarily complicated when read from left to right. In contrast, the notation "AND(A, B)" is a prefix notation, as the operation is mentioned first, followed by the operands. This allows for very simple parsing of a complex logical term, always processed from left to right.

An example: An assignment to an InputPort (on the left side of the term) is described, created using a complex operation from multiple OutputPorts: "EFUSE_1_PIN_IN0 = AND( OR ( EFUSE_1_PIN_OUT0, NOT( EFUSE_1_PIN_OUT1 ) ), NOT ( EFUSE_1_PIN_OUT2 ) )".

Wiring is Generated During the Startup of the Virtual System: During this process, several checks may be performed, such as: is the syntax of the description correct (e.g., proper use of parentheses in terms). Is the semantics of the operations correct (e.g., max. 1 PWM signal per operation). Are the signals used compatible (e.g., no mixing of Voltage and DIO). Are the connections consistent (e.g., not connecting Input to Input or Output to Output).

The nodes of the tree, i.e., the operations, may be technically implemented using C++ features. Each node may contains function pointers that are bound using std::bind. For signal evaluation, these functions are called, and their results are evaluated and passed on until the entire tree has been evaluated.

Evaluation of such a tree structure may be done in pre-order traversal. This means descending recursively in a specific order. The acyclic nature of the tree is ensured since it is a DAG (direct acyclic graph). This method allows certain operations to be executed faster: If the first operand of an OR operation is TRUE, the result is also TRUE. If the first operand of an AND operation is FALSE, the result is also FALSE. Other traversal methods can also be used. However, they do not allow for the mentioned short-path evaluation of the operations.

The disclosed method offers robust virtualization, error analysis, and the integration of additional tools for signal visualization. Moreover, it is possible to automatically generate integration into external tools (e.g., Canoe) based on the virtualization configuration, simplifying and accelerating applicability in specific projects.

Another challenge arises when considering the entire PCB (Printed Circuit Board) and the dependencies between the ICs (Microcontroller and Peripherals). A PCB is a complex, interconnected graph where the nodes correspond to ICs and the edges represent dependencies. Therefore, edges are not wires, but signal dependencies. There can be 1 to n wires on which various operations can take place.

The solution provided herein is based on the fact that the wiring does not contain cycles between peripherals. The only feedback channel leads back to the microcontroller. If there were cycles between peripherals, the system would not be able to stabilize. Based on this fact, we sort the nodes and edges so that they are processed in the correct order. An processing examples includes the steps: The microcontroller provides output data. Wires leading from this node are activated to transport signals to the next nodes (including operations like AND, OR, etc.). The next node is triggered to process its input data. The outgoing wires are activated again. This strategy repeats until the microcontroller is reached again. The microcontroller processes the input data, and the cycle begins anew.

This approach corresponds to a graph tree with levels. The graph tree with levels organizes nodes into distinct hierarchical levels, where each level represents a specific stage in the processing sequence. This structure ensures that dependencies are managed efficiently, with each node processing data only after its predecessors have completed their tasks.

In the present disclosure, any feature described in an embodiment, example, method (e.g. method 100), method step, and/or system (e.g. system 200), may be combined with any feature of another embodiment, example, method, method step, and/or system unless otherwise specified.

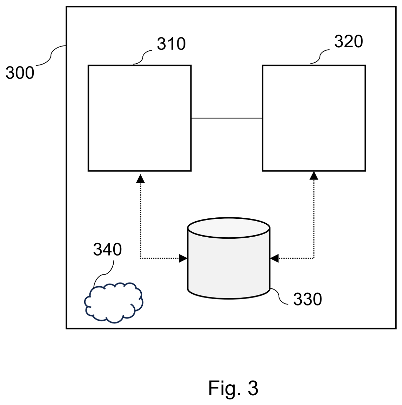

Fig. 3 schematically illustrates a block diagram of an embodiment of an apparatus 300 comprising one or more interfaces 310 for communication and one or more processors or data processing circuits 320 configured to execute any one of the methods described herein.

In embodiments, the apparatus may further comprise a memory or a storage medium 330. A storage medium 330 (or a data carrier, or a computer-readable data carrier, or a computer-readable medium) may comprise, stored thereon, a computer program or computer-executable instructions for performing one of the methods described herein when it is performed by one or more processors 320. The processors 320 may communicate with the storage medium 330 directly and/or via the one or more interfaces 310.

In embodiments, the one or more interfaces 310 may comprise wired and/or wireless interfaces for transmitting and/or receiving communication signals in connection with the execution of the proposed concept. In practice, the interfaces, e.g., comprise pins, wires, antennas, and/or the like. As well, the interfaces may comprise means for (analog and/or digital) signal or data processing in connection with the communication, e.g., filters, samples, analog-to-digital converters, signal acquisition and/or reconstruction means as well as signal amplifiers, compressors and/or any encryption/decryption means.

The data processing circuit 320 may correspond to or comprise any type of programable hardware. So, examples of the data processing circuit 320, e.g., comprise a memory, microcontroller, field programmable gate arrays, one or more central and/or graphical processing units. To execute the proposed method, the data processing circuit 320 may be configured to access or retrieve an appropriate computer program for the execution of the proposed method from a memory of the data processing circuit 320 or a separate memory which is communicatively coupled to the data processing circuit 320.

Some or all of the method steps described above with regard to Figures 1-2 may be implemented by a computer in that they are executed by (or using) a processor, a microprocessor, an electronic circuit, or the data processing circuit 320. For example, the implementation can be performed using a non-transitory storage medium such as a computer-readable storage medium or data carrier. Such computer-readable media include any media that can be accessed by either a general-purpose or a specialized computer system.

Furthermore, any component of apparatus 300 may be embedded locally on the autonomous system or located in the cloud 340. For instance, the data processing circuit (320) can be located in an edge device of the autonomous system, in the cloud 340 (e.g., a digital twin), or partially in both. Edge devices, equipped with edge AI capabilities, can perform real-time data processing and decision-making close to the source of data, reducing latency and improving response times. This is particularly helpful for autonomous systems that require immediate reactions to dynamic environments.

The cloud component 340 can leverage high-performance computing (HPC) resources and advanced machine learning models for more complex computations that are not time-sensitive. By utilizing cloud-based digital twins 340, which are virtual replicas of physical systems, the autonomous system can simulate various scenarios and optimize its performance based on real-time data and predictive analytics. This hybrid approach ensures that the system can handle both real-time processing and complex computations efficiently.

Additionally, the integration of 5G/6G technology (e.g. in communication interfaces 310) can further enhance this setup by providing high-speed, low-latency communication between the edge devices and the cloud 340. This ensures seamless data transfer and synchronization, enabling the autonomous system to make informed decisions quickly and accurately.

In summary, by combining edge AI, HPC, digital twins, and 5G/6G technology, the implementation of these methods becomes more robust, scalable, and efficient. This hybrid architecture not only enhances the performance and decision-making capabilities of the autonomous system but also ensures that it can adapt to various dynamic environments and scenarios effectively.

The apparatus 300 may also include a cloud implementation 340, which enhances its capabilities by leveraging cloud-based resources. This cloud implementation comprises several key components. The cloud implementation may comprise cloud interfaces 310' designed for communication between the local apparatus and the cloud. These interfaces enable data transfer, remote access, and integration with cloud services, ensuring seamless connectivity.

Additionally, the cloud implementation 340 may include cloud processors or data processing circuits 320'. These may be processing units located in the cloud, configured to execute any of the methods described for the apparatus. By utilizing cloud processors, the system can handle more complex computations and larger datasets without being limited by the local hardware's capabilities. This allows for greater flexibility and efficiency in processing tasks, as well as the ability to dynamically scale resources based on demand.

Furthermore, the cloud implementation 340 may include a cloud memory or storage medium 330' that may be responsible for storing data, datasets, and program/method code in the cloud. Cloud storage offers scalability, redundancy, and accessibility, ensuring that data is securely stored and can be accessed from anywhere. This enhances the overall reliability and availability of the system, providing robust data protection and disaster recovery options.

The cloud implementation 340 allows for flexibility in how the methods are executed. Specifically, any of the methods described herein can be partially executed in the cloud, where some parts of the method may be processed locally while others are offloaded to the cloud. This hybrid approach optimizes performance and resource utilization by balancing the load between local and cloud resources. Alternatively, the entire method can be fully executed in the cloud, leveraging the cloud's extensive computational power and storage capabilities. This dual implementation (local and cloud) ensures that the apparatus can efficiently handle a wide range of tasks, from simple local processing to complex cloud-based computations, providing a robust and scalable solution that can adapt to varying workloads and operational requirements.

## Claims

1. A computer-implemented method for virtualizing an electronic control system, ECS, comprising:
1. abstracting (110) technical details of signals in ECS components, comprising categorizing said signals into groups, including analog signals group and digital signals group, thereby facilitating distinct processing paths for different signal groups;
2. obtaining (120) peripheral models associated with respective ECS components, each peripheral model comprising interfaces that correspond to respective interfaces of the respective ECS component, each interface of the peripheral model being associated with a signal, which is an analog signal or a digital signal, an input signal or an output signal, matching an interface signal of the respective ECS component;
3. obtaining (130) signal operations for simulating signal processing between the peripheral models, said signal operations including logical operations for the digital signals and mathematical operations for the analog signals;
4. executing (140) the signal operations to evaluate the signal processing between the ECS components;
5. using (150) said evaluation of the signal processing and/or the executed signal operations by a machine learning model to predict cascading malfunctions across multiple ECS components;
6. adapting (160) the ECS components that are predicted to malfunction, thereby ensuring continuous and reliable operation of the ECS.

2. The method of claim 1, wherein the evaluation of the signal processing comprises analog and digital signal evaluation data, and wherein the method further comprises interpreting said analog and digital signal evaluation data using a semantic model configured to:
• represent ECS system states and operational scenarios;
• detect semantic inconsistencies in combinations of analog and/or digital signals based on contextual rules;
wherein the detected inconsistencies are used to trigger anomaly alerts or initiate adapting the ECS components that are predicted to malfunction in step 5.

3. The method of claim 2, wherein the semantic model comprises a rule-based ontology or a knowledge graph representing ECS system states and relationships between analog and digital signal conditions.

4. The method of claim 2 or 3, wherein interpreting the analog and digital signal evaluation data using the semantic model comprises:
• mapping said signal evaluation data to semantic entities representing ECS components and ECS system states;
• applying contextual rules to evaluate the logical coherence of the mapped entities; and
• generating alerts or annotations for signal combinations that violate semantic consistency.

5. The method of any previous claim, wherein the machine learning model is a multi-layer perceptron, MLP, or a graphical neural network, GNN, or any machine learning model, trained on historical analog and digital signal data representing dependencies between ECS components.

6. The method of claim 5, wherein the machine learning model is configured to operate in a hybrid mode, comprising:
• offline training on historical analog and digital signal data; and
• real-time inference during simulation to emulate the prediction of Step 5.

7. The method of any previous claim, further comprising dynamically validating signal consistency during simulation by:
• monitoring transitions of the analog and digital signal data generated in step 4;
• verifying that the analog signals remain within predefined valid ranges;
• verifying that the digital signals remain within binary states;
• checking logical consistency of signal transitions between ECS components;
wherein validation results are used to support anomaly prediction in step 5 or adapting the ECS components that are predicted to malfunction in step 6.

8. The method of any previous claim, wherein the signal operations obtained in step 3 include at least one of: AND, OR, XOR, and NOT for digital signals, and at least one of: multiplication (MUL) and addition (ADD) for analog signals.

9. The method of any of claims 1 to 13, wherein adapting the ECS components that are predicted to malfunction comprises software-based corrections and/or hardware-based corrections.

10. The method of any previous claim, wherein the system is configured to generate a visual representation of the signal flow and validation results, including:
• highlighting inconsistent or anomalous signal paths;
• annotating signal nodes with validation status and predicted failure probabilities.

11. A system for virtualizing and electronic control system, ECS, comprising:
a signal abstraction module (210) configured to abstract signals in ECS components (202), comprising categorizing said signals into categorized groups, including analog signals group (215) and digital signals group (220), thereby facilitating distinct processing paths for different signal groups;
a standardized interface module (203) configured to encapsulate peripheral models (204) with respective ECS components (202), each peripheral model comprising interfaces that correspond to respective interfaces of the respective ECS component, each interface of the peripheral model being associated with a signal, which is an analog signal or a digital signal, an input signal or an output signal, matching an interface signal of the respective ECS component;
a signal operations module (225) configured to obtain, for simulating signal processing between the peripheral models (205), signal operations that represent signal processing between the respective ECS components, said signal operations including logical operations (230) for the digital signals, and mathematical operations (235) for the analog signals, thereby providing a unified framework for signal manipulation;
a signal evaluation module (240) configured to execute the signal operations (230, 235) to evaluate the signal processing between the ECS components;
a prediction module (245) comprising a machine learning model configured to use said evaluation of the signal processing and/or the executed signal operations to predict cascading malfunctions across multiple ECS components; and
a component adaptation module (250) configured to adapt the ECS components that are predicted to malfunction, thereby ensuring continuous and reliable operation of the ECS.

12. A computer program comprising instructions which, when the computer program is executed by a computer, cause the computer to carry out a method of any one of claims 1 to 11.

13. A computer-readable data carrier having stored thereon the computer program of claim 13.

14. An apparatus (300) comprising:
one or more interfaces (310) for communication;
a memory (330); and
a data processing circuit (320) configured to carry out the method of any one of claims 1 to 11.
